(19) Europäisches Patentamt
European Patent Office
Office européen des brevets

(11) EP 1 621 931 B1

(12) EUROPEAN PATENT SPECIFICATION

(45) Date of publication and mention of the grant of the patent:
**03.06.2015 Bulletin 2015/23**

(51) Int Cl.:
*G03F 7/20* (2006.01) *G03F 7/11* (2006.01)

(21) Application number: **05014745.3**

(22) Date of filing: **07.07.2005**

(54) **Protective film-forming composition for immersion exposure and pattern-forming method using the same**

Schutzfilm bildende Zusammensetzung für eine Immersionsbelichtung und Strukturausbildungsverfahren mit einer solchen Zusammensetzung

Composition formant un film protecteur pour une exposition par immersion et procédé de fabrication de motifs employant ladite composition

(84) Designated Contracting States:
**AT BE BG CH CY CZ DE DK EE ES FI FR GB GR HU IE IS IT LI LT LU LV MC NL PL PT RO SE SI SK TR**

(30) Priority: **08.07.2004 JP 2004201457**

(43) Date of publication of application:
**01.02.2006 Bulletin 2006/05**

(73) Proprietor: **FUJIFILM Corporation**
**Minato-ku**
**Tokyo (JP)**

(72) Inventors:
- **Inabe, Haruki**
  **Yoshida-cho**
  **Haibara-gun**
  **Shizuoka (JP)**
- **Kanna, Shinichi**
  **Yoshida-cho**
  **Haibara-gun**
  **Shizuoka (JP)**
- **Kanda, Hiromi**
  **Yoshida-cho**
  **Haibara-gun**
  **Shizuoka (JP)**

(74) Representative: **Hoffmann Eitle**
**Patent- und Rechtsanwälte PartmbB**
**Arabellastraße 30**
**81925 München (DE)**

(56) References cited:
**US-A- 5 955 241 US-A1- 2004 075 895**

- **S. KISHIMURA ET AL.: "Resist interaction in 193-/157-nm immersion lithography" PROCEEDINGS OF THE SPIE - THE INTERNATIONAL SOCIETY FOR OPTICAL ENGINEERING, vol. 5376, no. 1, February 2004 (2004-02), pages 44-55, XP002352337 USA**
- **D.S. HALL ET AL.: "Dissolution behavior of fluoroalcohol substituted polystyrenes" PROCEEDINGS OF THE SPIE - THE INTERNATIONAL SOCIETY FOR OPTICAL ENGINEERING, vol. 4345, no. 2, February 2001 (2001-02), pages 1066-1072, XP002352338 USA**
- **T. OHFUJI ET AL.: "Dissolution behavior of alicyclic polymers designed for ArF excimer laser lithography" PROCEEDINGS OF THE SPIE - THE INTERNATIONAL SOCIETY FOR OPTICAL ENGINEERING, vol. 2724, no. 1, February 1996 (1996-02), pages 386-398, XP002352339 USA**
- **T. ISHIKAWA ET AL.: "The dissolution behavior of tetrafluoroethylene-based fluoropolymers for 157-nm resist materials" PROCEEDINGS OF THE SPIE - THE INTERNATIONAL SOCIETY FOR OPTICAL ENGINEERING, vol. 5376, no. 1, February 2004 (2004-02), pages 169-177, XP002352340 USA**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 621 931 B1

## Description

## Background of the Invention

1. Field of the Invention

The present invention relates to a method of forming a protective film for immersion exposure for use in manufacturing processes of semiconductor devices, such as IC, manufacture of circuit substrates for liquid crystals, thermal heads and the like, and lithographic processes of other photo-fabrication, and also the invention relates to a pattern-forming process using the protective film forming method. In particular, the invention relates to a method of forming a protective film-forming composition for immersion exposure suitable for exposure with an immersion projection exposure apparatus using far ultraviolet rays of 300 nm or less as the light source, and a pattern-forming process using the same.

2. Description of the Related Art

With the progress of fining of semiconductor elements, shortening of the wavelengths of exposure light source and increasing of the numerical aperture (high NA) of projection lens have advanced, and now exposure apparatus ofNA 0.84 using an ArF excimer laser having the wavelength of 193 nm as the light source have been developed, which can be expressed by the following equations as generally known:

$$(\text{Resolution}) = k_1 \cdot (\lambda/\text{NA})$$

$$(\text{Depth of focus}) = \pm k_2 \cdot \lambda/\text{NA}^2$$

wherein $\lambda$ is the wavelength of exposure light source, NA is the numerical aperture of the projection lens, and $k_1$ and $k_2$ are the coefficients concerning the process.

For further higher resolution by the shortening of wavelengths, an exposure apparatus with an $F_2$ excimer laser having the wavelength of 157 nm as the light source has been studied, but the materials of lens for use in the exposure apparatus for the shortening of wavelengths and the materials of resist are extremely restricted, so that the realization of the reasonable manufacturing costs of the apparatus and materials and quality stabilization are very difficult, as a result, there are possibilities of missing an exposure apparatus and a resist having sufficient performances and stabilities within a required period of time.

As a technique for increasing resolution in optical microscopes, a so-called immersion method of filling a liquid of high refractive index (hereinafter also referred to as "immersion liquid") between a projection lens and a sample has been conventionally known.

As "the effect of immersion", the above resolution and depth of focus can be expressed by the following equations in the case of immersion, with $\lambda_0$ as the wavelength of the exposure light in the air, n as the refractive index of immersion liquid to the air, and $NA_0 = \sin\theta$ with $\theta$ as convergence half angle of the ray of light:

$$(\text{Resolution}) = k_1 \cdot (\lambda_0/n)/\text{NA}_0$$

$$(\text{Depth of focus}) = \pm k_2 \cdot (\lambda_0/n)/\text{NA}_0^2$$

That is, the effect of immersion is equivalent to the case of using exposure wavelength of the wavelength of 1/n. In other words, in the case of the projection optical system of the same NA, the depth of focus can be made n magnifications by immersion.

This is effective for every pattern form, further, this can be combined with super resolution techniques such as a phase shift method and a deformation lighting method now under discussion.

As the example of apparatus applying this effect to the transfer of micro-fine pattern of semiconductor element, JP-A-57-153433 and JP-A-7-220990 are known, but resists suitable for immersion exposure techniques are not disclosed in these patents.

S. Kishimura et al., in Proceedings of SPIE Vol. 5376, 02/2004, pp.44-55 report on their study of the interaction

of certain types of resists with water and perfluoropolyether (PFPE) as immersion fluids. D.S. Hall et al., Proceedings of SPIE Vol. 4345, 02/2001, pp.1066-1072; T. Ohfuji et al., Proceedings in SPIE Vol. 2724, 02/1996, pp.386-398; and T. Ishikawa et al., Proceedings in SPIE Vol. 5376, 02/2004, pp.169-177 relate to the dissolution behavior of specific resist materials. US 5,955,241 is concerned with chemical-amplification-type negative resist compositions.

It is appointed in JP-A-10-303114 that the control of the refractive index of an immersion liquid is important since the variation of the refractive index of an immersion liquid causes the deterioration of a projected image due to the wave surface aberration of exposure apparatus, and controlling the temperature coefficient of the refractive index of an immersion liquid to a certain range, and water added with additives for reducing surface tension or increasing the degree of surface activity are disclosed as a preferred immersion liquid. However, the specific additives are not disclosed and resists suitable for the technique of immersion exposure are not also discussed.

The latest technical progress of immersion exposure is reported in SPIE Proc., 4688, 11 (2002), and J. Vac. Sci. Tecnol. B, 17 (1999). When an ArF excimer laser is used as the light source, it is thought that pure water (having refractive index of 1.44 at 193 nm) is most promising as the immersion liquid in the light of the safety in handling, the transmittance and the refractive index at 193 nm.

When an $F_2$ excimer laser is used as the light source, a solution containing fluorine is discussed from the balance of the transmittance and the refractive index at 157 nm; but a sufficiently satisfactory solution from the viewpoint of the environmental safety and at the point of refractive index has not been found yet. From the extent of the effect of immersion and the degree of completion of resist, it is thought that immersion exposure technique will be carried on an ArF exposure apparatus earliest:

From the advent of the resist for a KrF excimer laser (248 nm) on, an image-forming method that is called chemical amplification is used as the image-forming method of the resist for compensating for the reduction of sensitivity by light absorption. To explain the image-forming method of positive chemical amplification by example, this is an image-forming method of exposing a resist to decompose an acid generator in the exposed area to thereby generate an acid, utilizing the generated acid as the reactive catalyst to change an alkali- insoluble group to an alkali-soluble group by the bake after exposure (PEB: Post Exposure Bake), and removing the exposed area by alkali development.

In immersion exposure, a resist film is exposed through a photomask in the state of filling an immersion liquid between the resist film and the optical lens, to transfer the pattern of the photomask to the resist film. At this time, there are cases where an image is not formed by the osmosis of an immersion liquid into the inside of a resist film (Nikkei Micro-device, April 2004). Further, it is imagined that organic substances and the like are eluted from a resist film and get into an immersion liquid as impurities and contaminate a lens and an exposure apparatus to thereby hinder exposure.

As a solution to avoid such problems, a method of providing a protective film between a resist film and a lens (hereinafter also referred to as "a topcoat" or "an overcoat") so that a resist and water do not come in contact directly is known (e.g., Nikkei Micro-device, April 2004). US 2004/0075895 A1 provides a similar teaching.

It is not clarified yet that what materials are suitable for topcoat. However, there is apprehension that if a topcoat is exposed to an immersion liquid at the time of immersion exposure and the film thickness of the topcoat increases by swelling, an optical image that has to be projected faithfully to a resist film may be distorted. Further, it was found from the studies by the present inventors that there are cases where the sectional form of a resist pattern formed on a lower layer is impaired depending upon the material of the topcoat, and the solution of these problems are desired.

## Summary of the Invention

An object of the invention is to provide a protective film-forming composition for immersion exposure capable of peeling in developing processing in the fine pattern-forming process by immersion exposure, little in swelling by the immersion liquid at the time of immersion exposure, and capable of forming a good resist pattern after development.

The above objects of the invention are solved by the method of forming a protective film and pattern forming method as defined in the appended claims.

## Brief Description of the Drawings

Fig. 1 is a schematic drawing of a laboratory apparatus of two-beam interference exposure.

## Detailed Description of the Invention

The invention is described in detail below.

When a composition for use in the protective film forming method of the present invention (referred to as a protective film-forming composition for immersion exposure in the invention, hereafter), as a dry film, has a dissolution rate in an alkali developer of 20 nm/sec or more, preferably 25 nm/sec or more, more preferably 30 nm/sec or more, and still more preferably 40 nm/sec or more, the sectional form of a resist obtained after development (after peeling of

a protective film) can be prevented from becoming T-top. Further, by making the dissolution rate in an alkali developer of the dry film 300 nm/sec or less, preferably 200 nm/sec or less, more preferably 90 nm/sec or less, and still more preferably 80 nm/sec or less, the swelling amount of a protective film in an immersion liquid can be reduced, and the sectional form of a resist obtained after development (after peeling of a protective film) can be prevented from becoming a round top form (a form that the top of a resist pattern becomes round).

The dissolution rate in an alkali developer of a protective film-forming composition for immersion exposure as a dry film can be measured by the following method.

A protective film-forming composition for immersion exposure is coated on a substrate, and the composition is heated to dry the solvent to thereby form a protective film. The dissolution rate of the protective film in a 2.38 mass% aqueous solution of tetramethylammonium (an alkali developer) at 23°C is measured with a resist dissolution rate analyzer (RDA 790, manufactured by Litho Tech Japan Co., Ltd.). Incidentally, " mass%" means "weight %" in this specification.

In addition to water-insoluble resin (X), a protective film-forming composition for immersion exposure in the invention generally contains coating solvent (Y) and further, if necessary, can contain surfactant (Z) and other components. Each of these components is described below.

(1) Water-insoluble resin (X)

Water-insoluble resin (X) contained in a protective film-forming composition for immersion exposure in the invention is a component having an important role in adjusting the dissolution rate of a protective film in an alkali developer.

The term "a resin is water-insoluble" means that when a protective film-forming composition for immersion exposure containing the resin is coated on a silicon wafer and dried, the dried protective film is soaked in pure water at 23°C for 10 minutes, then dried, and the thickness of the film is measured, if the thickness does not decrease, the resin is water-insoluble.

By the water insolubility of resin (X), it becomes possible for the protective film for immersion exposure to perform the role of preventing the osmosis of an immersion liquid into the inside of the resist film and the elution of resist film components into the immersion liquid.

Water-insoluble resin (X) is not particularly restricted, but it is preferred that water-insoluble resin (X) contains at least one repeating unit selected from repeating unit (X-1) derived from a monomer having a pKa of less than 8 (hereinafter also referred to as "a low pKa monomer") and repeating unit (X-2) derived from a monomer having a pKa of 8 or more (hereinafter also referred to as "a high pKa monomer").

A low pKa monomer contains a functional group (an acid group) having a pKa of less than 8 The acid groups contained in a low pKa monomer are not particularly limited so long as the pKa is less than 8, preferably from 2 to 8, and the examples of low pKa monomers include carboxylic acids, ammonium salts and pyridinium salts.

pKa here means the pKa described in Kagaku Binran II (Chemical Handbook II), 4th Edition (revised version), compiled by Nippon Kagaku-kai, published by Maruzen Co (1993), and the value of pKa is a value measured with an infinite dilution solution at 25°C.

The preferred examples of repeating unit (X-1) derived from a low pKa monomer are exemplified below, but the invention is not limited to these examples.

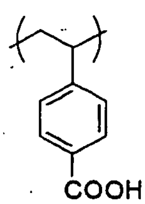
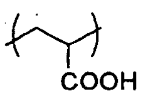
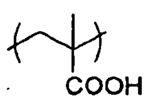
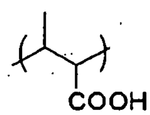
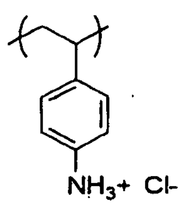
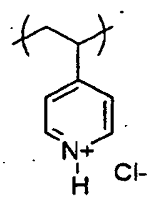

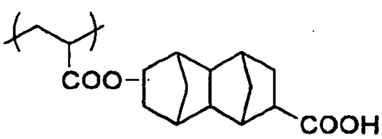
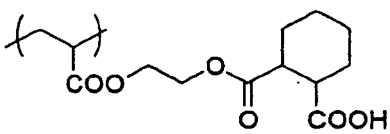

A protective film-forming composition for immersion exposure in the invention may contain, as water-insoluble resin (X), water-insoluble resin (X) having repeating unit (X-2) derived from a monomer having an acid dissociation constant pKa of 8 or more.

The monomers having a pKa of 8 or more are not particularly restricted, and monomers containing an acid group (an alkali- soluble group), e.g., a phenolic hydroxyl group, a sulfonamide group, $-COCH_2CO-$, and a fluoro-alcohol group are exemplified. Monomers containing a fluoro-alcohol group are particularly preferred. The fluoro-alcohol group is a fluoroalkyl group substituted with at least one hydroxyl group, preferably having from 1 to 10 carbon atoms, more preferably from 1 to 5 carbon atoms.

As the specific examples of the fluoro-alcohol groups, e.g., $-CF_2OH$, $-CH_2CF_2OH$, $-CH_2CF_2CF_2OH$, $-C(CF_3)_2OH$, $-CF_2CF(CF_3)OH$ and $-CH_2C(CF_3)_2OH$ can be exemplified. The particularly preferred fluoro-alcohol group is a hexafluoroisopropanol group.

The monomers may contain only one or two or more acid groups. The repeating unit derived from the monomers preferably have two or more acid groups per one repeating unit, more preferably from 2 to 5 acid groups, and particularly preferably from 2 to 3 acid groups.

By containing water-insoluble resin (X) having repeating unit (X-2) derived from the monomer having pKa of 8 or more, preferably from 8 to 13, smooth solubility can be obtained even in a weak basic alkali developer used in resist development.

The preferred specific examples of the repeating units derived from the monomer having pKa of 8 or more are shown below, but the invention is not limited to these compounds.

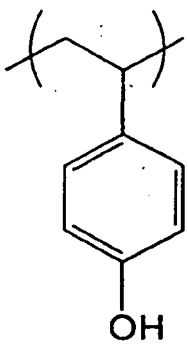
(pKa=10)

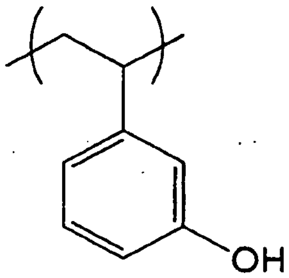
(pKa=10)

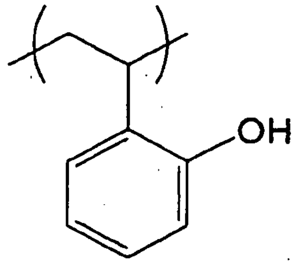
(pKa=10)

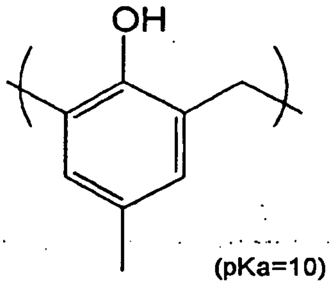

(pKa=10)

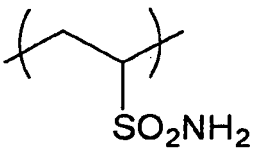

(pKa=10)

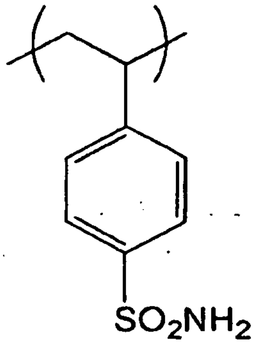

(pKa=10)

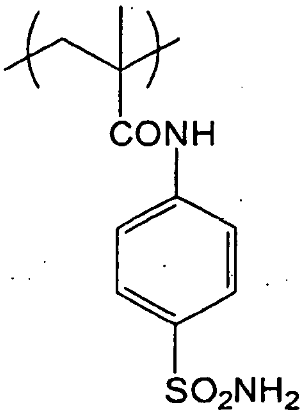

(pKa=10)

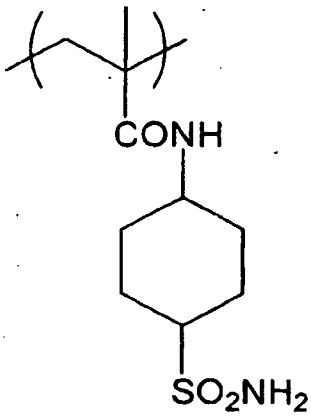

(pKa=10)

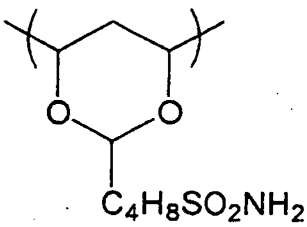

(pKa=10)

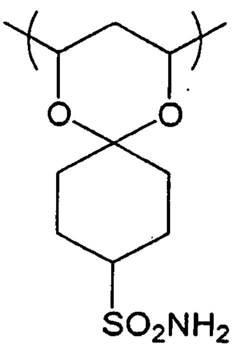

(pKa=10)

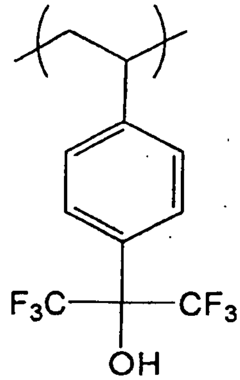

(pKa=9)

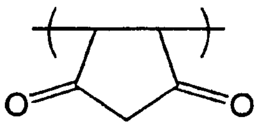

(pKa=9)

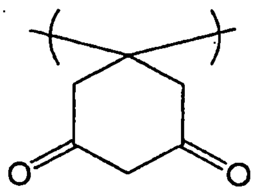

(pKa=9)

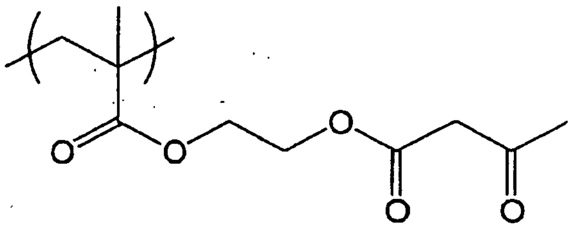

(pKa=9)

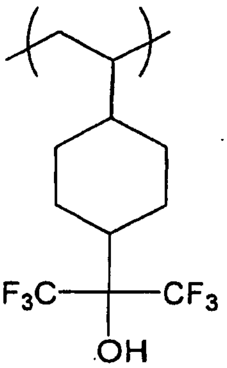

(pKa=9)

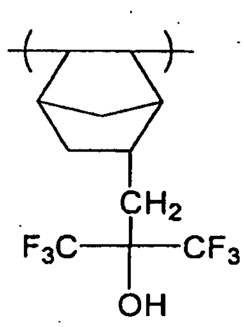

(pKa=9)

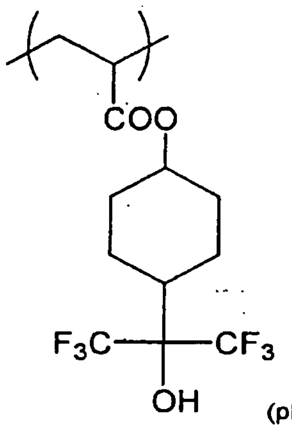

(pKa=9)

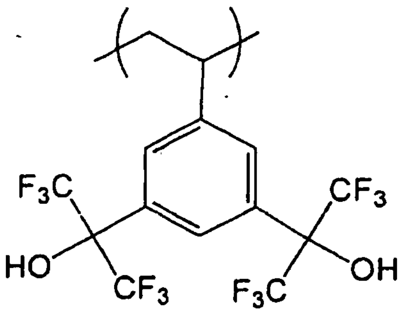

(pKa=9)

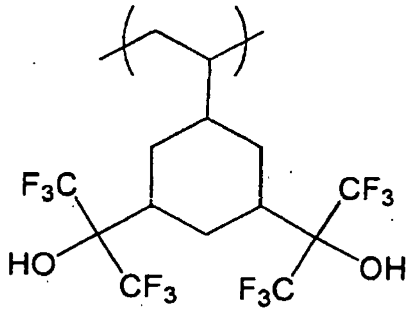

(pKa=9)

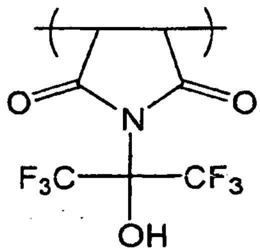

(pKa=9)

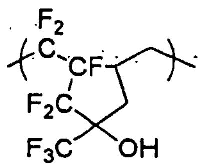

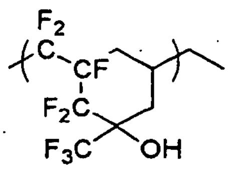

A dissolution rate in an alkali developer in film forming of a protective film-forming composition for immersion exposure in the invention can be controlled by adjusting the acid value of water-insoluble resin (X) contained in the composition and the acidity (pKa) of the monomer corresponding to the repeating unit constituting water-insoluble resin (X).

Repeating units (X-1) and (X-2) derived from the above monomers are repeating units to make resin (X) alkali-soluble, and the dissolution rate of a protective film in an alkali developer can be controlled by adjusting the proportion of the contents of these repeating units in resin (X).

When resin (X) contains repeating unit (X-1) derived from a low pKa monomer, it is preferred to contain repeating unit (X-1) derived from a low pKa monomer so that the acid value (milli-equivalent/g) of resin (X) becomes from 1.0 to 5.0, more preferably from 2.0 to 4.5.

When resin (X) contains repeating unit (X-2) derived from a high pKa monomer, it is preferred to contain repeating unit (X-2) derived from a high pKa monomer so that the acid value of resin (X) becomes from 3.0 to 7.0, more preferably from 3.5 to 5.5.

Resin (X) may contain both repeating unit (X-1) derived from a low pKa monomer and repeating unit (X-2) derived from a high pKa monomer as the repeating units constituting resin (X). In such a case, it is preferred that the proportion of repeating units (X-1) and (X-2) is optionally adjusted so that the acid value of resin (X) becomes from 2.0 to 5.0, more preferably from 2.5 to 4.5.

By containing repeating units (X-1) and (X-2) in the above range, it is possible to control the dissolution rate in an alkali developer to the range specified in the invention while securing the insolubility in water of a protective film-forming composition for immersion exposure.

Besides the above repeating structural units, resin (X) can contain various repeating structural units. As monomers for forming other containable repeating structural units, compounds having one addition polymerizable unsaturated bond selected from, e.g., acrylic esters, methacrylic esters, acrylamides, methacrylamides, allyl compounds, vinyl ethers and vinyl esters, etc., can be exemplified. In addition to these compounds, addition polymerizable unsaturated compounds copolymerizable with the monomers corresponding to the above various repeating structural units may be copolymerized.

Resin (X) is preferably transparent in the exposure light source to be used, since light reaches a resist film through a protective film in the time of exposure. When a protective film-forming composition for immersion exposure containing resin (X) is used in ArF immersion exposure, it is preferred that resin (X) does not have an aromatic group in view of the transparency to ArF light.

The specific examples of water-insoluble resins (X) having repeating unit (X-1) derived from a low pKa monomer are shown below. However, the invention is not limited to these compounds.

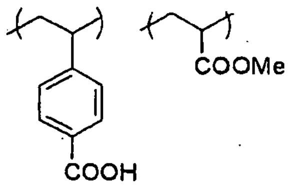

(a-1)

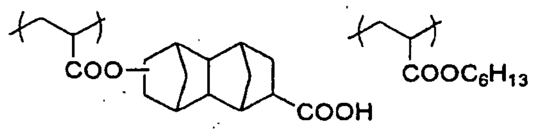

(a-2)

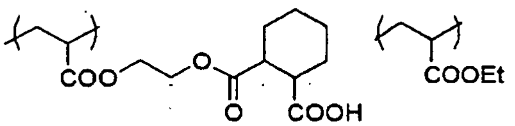

(a-3)

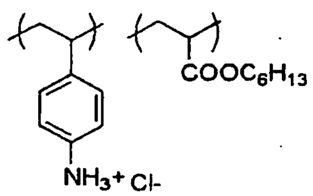

(a-4)

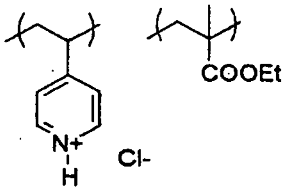

(a-5)

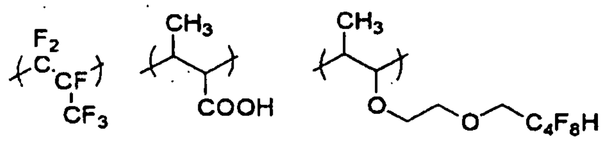

(a-6)

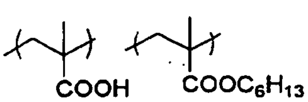

(a-7)

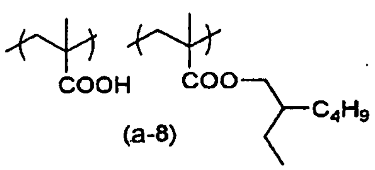

(a-8)

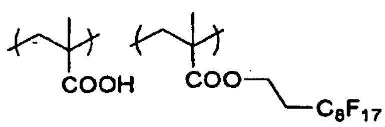

(a-9)

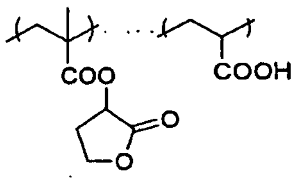

(a-10)

The preferred specific examples of water-insoluble resins (X) having repeating unit (X-2) derived from a monomer having an acid dissociation constant pKa of 8 or more are shown below. However, the invention is not limited to these compounds.

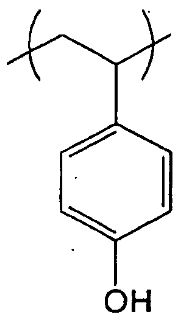

(A-1)

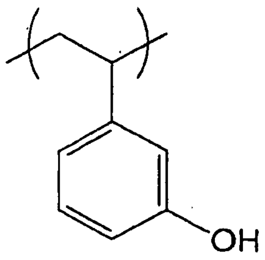

(A-2)

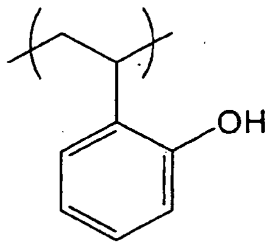

(A-3)

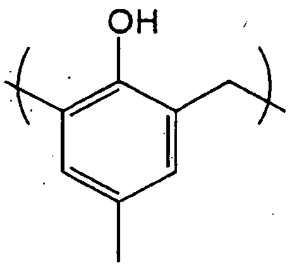

(A-4)

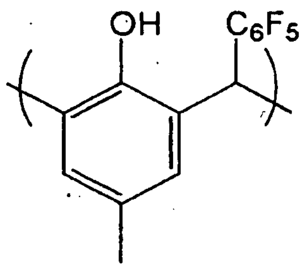

(A-5)

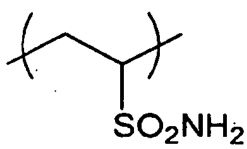

(A-6)

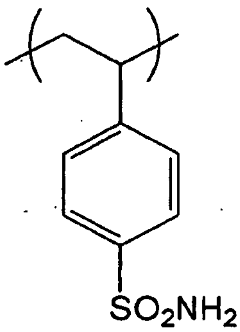

(A-7)

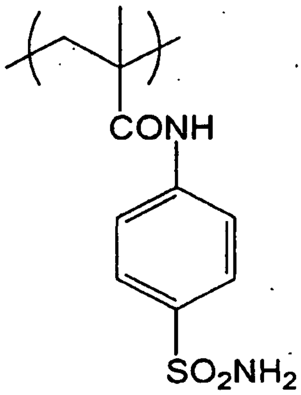

(A-8)

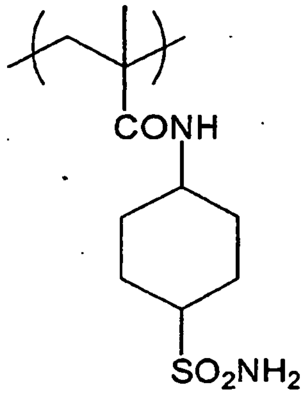

(A-9)

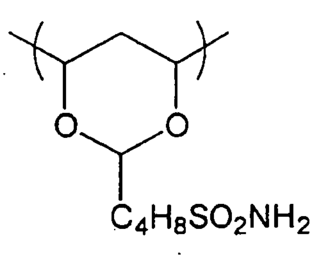

(A-10)

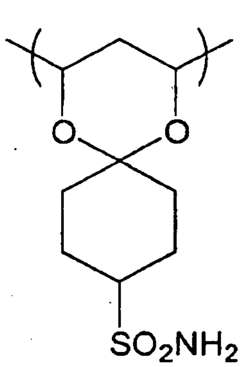

(A-11)

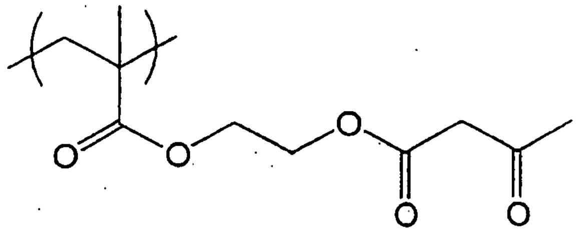

(A-12)

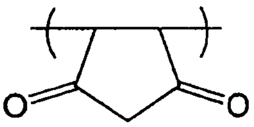

(A-13)

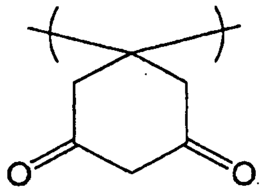

(A-14)

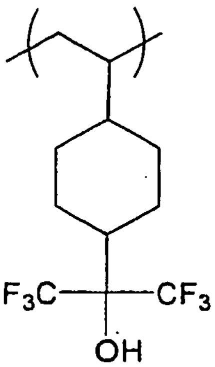

(A-16)

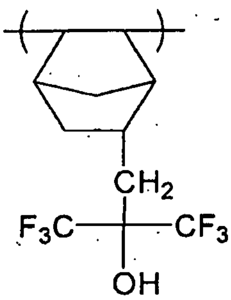

(A-17)

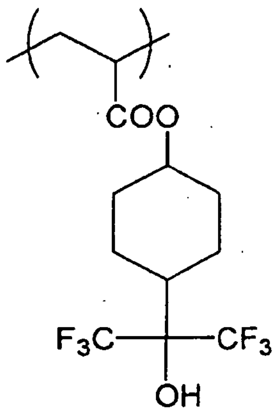

(A-18)

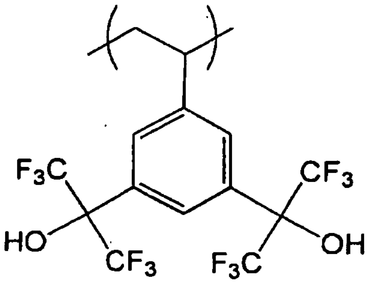

(A-19)

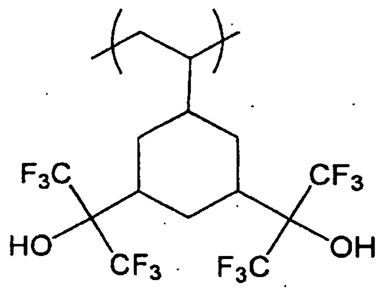

(A-20)

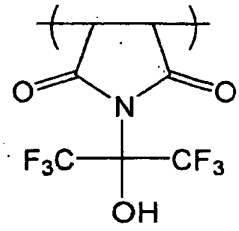

(A-21)

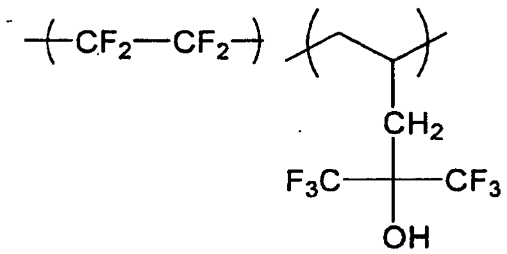

(A-22)

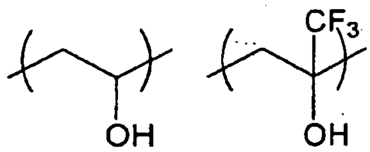

(A-23)

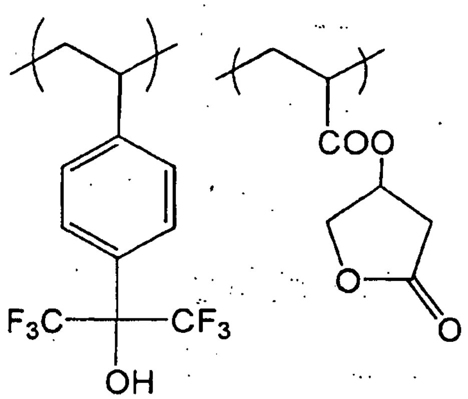

(A-24)

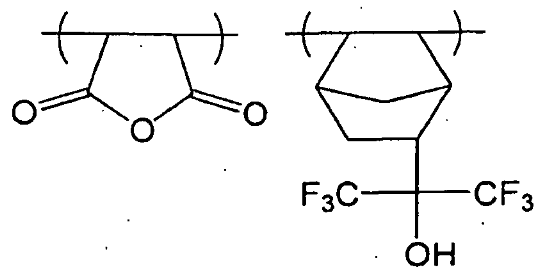

(A-25)

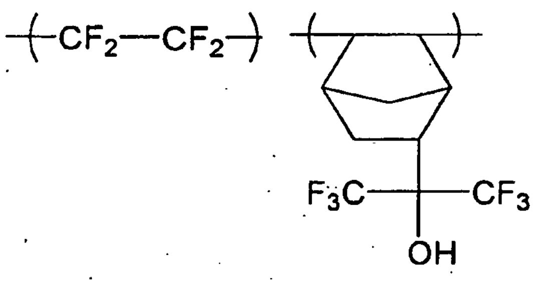

(A-26)

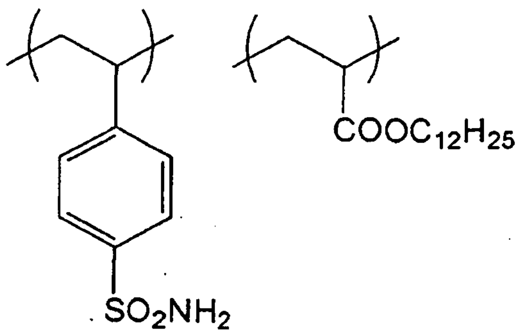

(A-27)

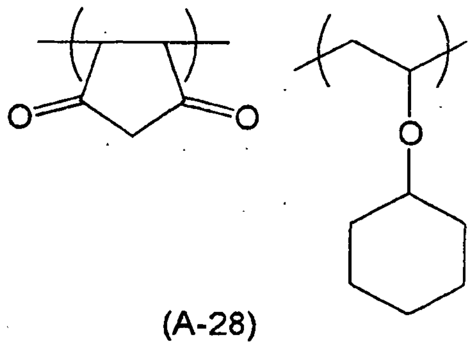

(A-28)

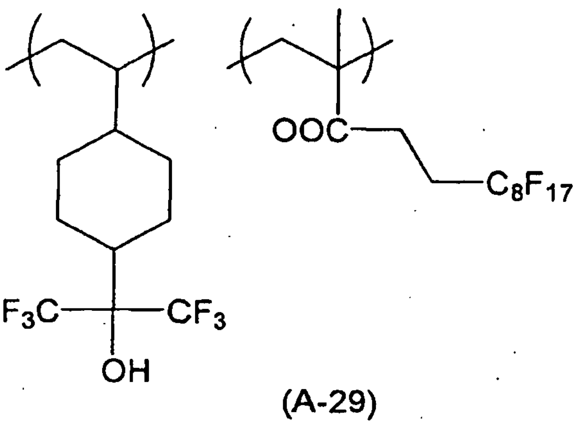

(A-29)

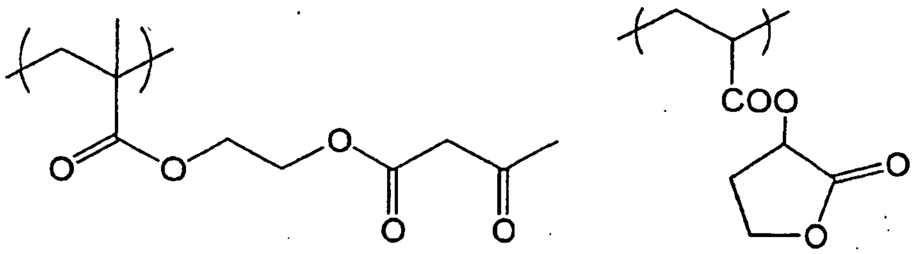

(A-30)

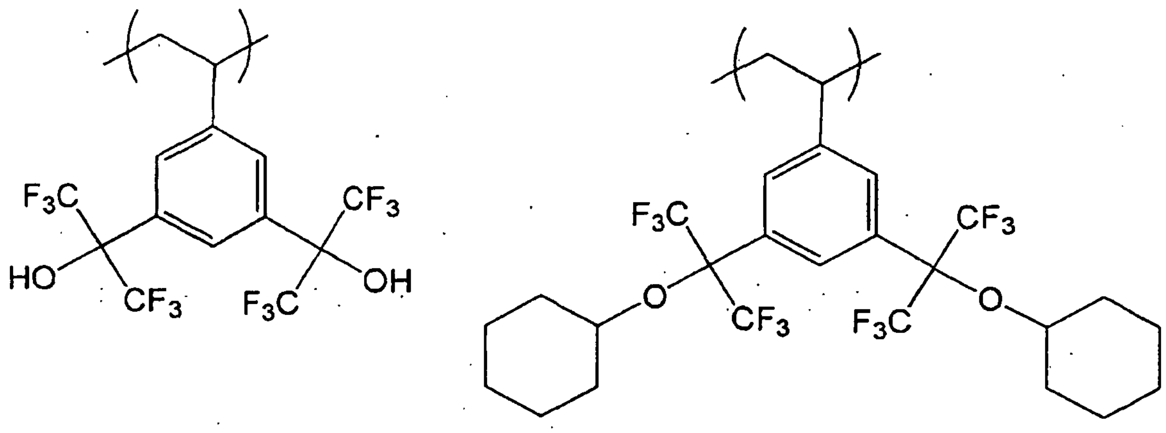

(A-31)

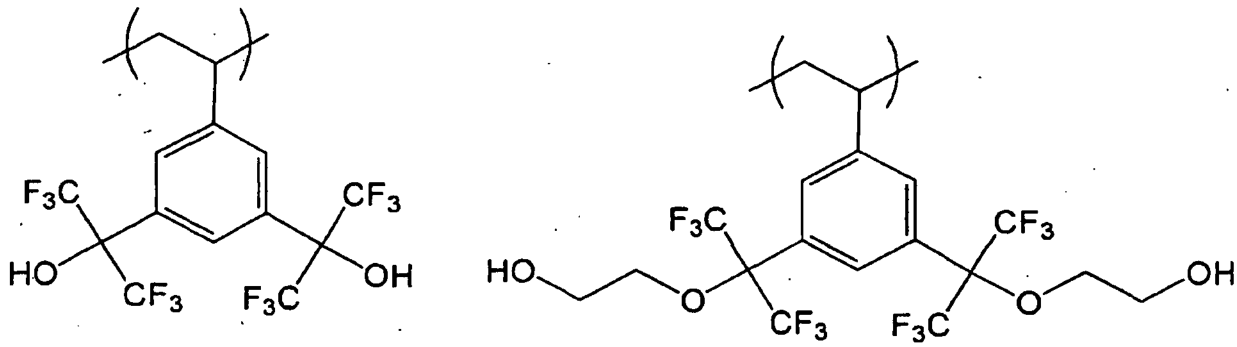

(A-32)

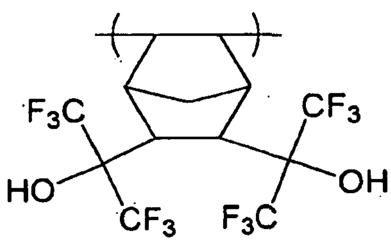

(A-33)

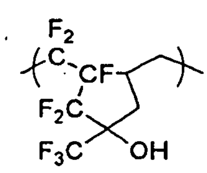

(A-34)

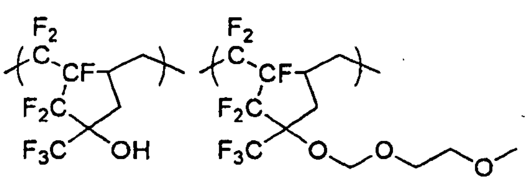

(A-35)

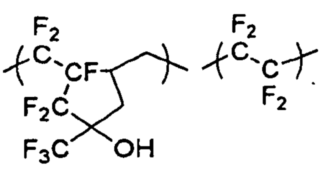

(A-36)

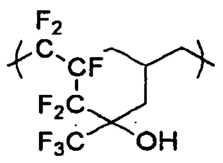

(A-37)

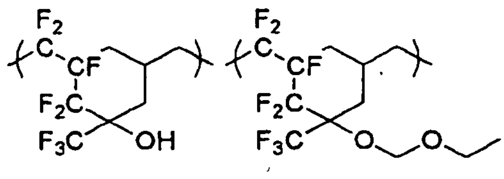

(A-38)

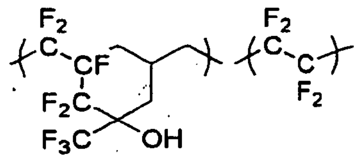

(A-39)

The preferred specific examples of water-insoluble resins (X) having both repeating unit (X-1) derived from a monomer having an acid dissociation constant pKa of less than 8 and repeating unit (X-2) derived from a monomer having an acid dissociation constant pKa of 8 or more are shown below. However, the invention is not limited to these compounds.

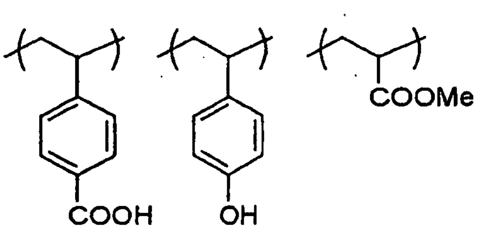

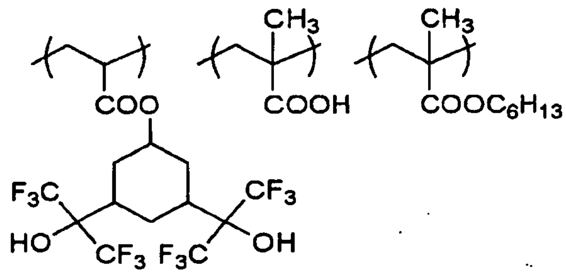

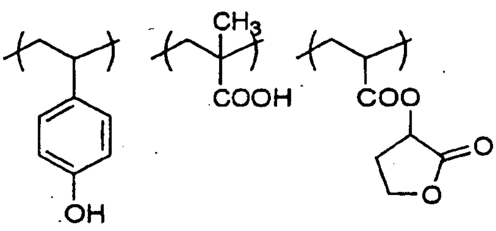

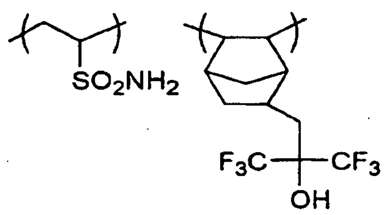

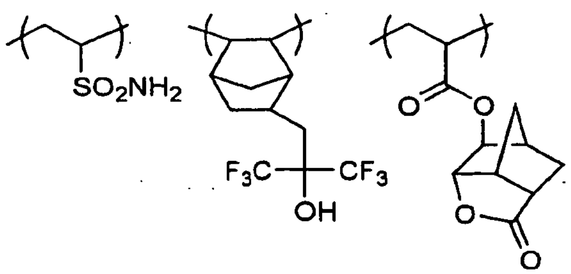

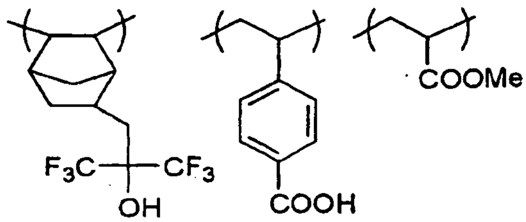

Water-insoluble resin (X) can be synthesized according to ordinary method (e.g., radical polymerization).

For example, as a general synthesizing method, a monomer seed is put in a reaction vessel en bloc or during the reaction, dissolved homogeneously with a reaction solvent according to necessity, such as ethers, e.g., tetrahydrofuran, 1,4-dioxane, or diisopropyl ether, ketones, e.g., methyl ethyl ketone or methyl isobutyl ketone, ester solvents, e.g., ethyl acetate, or the later-described solvents for use for dissolving the composition of the invention, e.g., propylene glycol monomethyl ether acetate, heated according to necessity under inert gas atmosphere, e.g., nitrogen or argon, and then polymerization is initiated with a commercially available radical polymerization initiator (e.g., azo initiator or peroxide). If desired, the initiator is added all at one time or dividedly, and after reaction termination, the reactant is put in a solvent and a desired polymer is recovered as powder or solid. The concentration of reaction is generally 20 mass% or more, preferably 30 mass% or more, and more preferably 40 mass% or more. The reaction temperature is generally from 10 to 150°C, preferably from 30 to 120°C, and more preferably from 50 to 100°C.

The synthesis of water-insoluble resin (X) is not limit to the radical polymerization and various synthesizing methods can be used. For example, besides the radical polymerization, cationic polymerization, anionic polymerization, addition polymerization, cyclic polymerization, polyaddition, polycondensation and addition condensation can be used for the synthesis of water-insoluble resin (X).

In addition, commercially available various resins can also be used.

The repeating structural units-may be used alone, or a plurality of repeating units may be used as mixture. In the invention, resins may be used alone or a plurality of resins may be used in combination.

The weight average molecular weight of water-insoluble resin (X) in terms of polystyrene by a gas permeation chromatography (GPC) method is preferably 1,000 or more, more preferably from 1,000 to 200,000, and still more preferably from 3,000 to 20,000.

In water-insoluble resin (X), the residual monomer is preferably 5 mass% or less in view of the inhibition of eluate and the like, more preferably the residual monomer is 3 mass% or less.

The molecular weight distribution (Mw/Mn, also referred to as the degree of dispersion) is generally in the range of from 1 to 5, preferably from 1 to 4, and more preferably from 1 to 3.

In the protective film-forming composition for immersion exposure in the invention, the blending amount of water- insoluble resin (X) is preferably from 60 to 100 mass% of the total solids content of the protective film-forming composition for immersion exposure, more preferably from 70 to 100 mass%.

<u>(2) Solvent (Y)</u>

A protective film-forming composition for immersion exposure in the invention is generally prepared by solving these components in a prescribed organic solvent. It is preferred that this solvent is different from an organic solvent used in a resist to avoid the admixture with the resist. In view of the prevention of elution into an immersion liquid, the solvent is preferably a nonaqueous solvent. The solvent having a boiling point of from 100 to 200°C is preferred.

In the invention, solvents may be used alone or two or more solvents may be used as mixture.

As usable solvents, for example, the following solvents are exemplified. Hydrocarbon solvents, e.g., benzene, toluene, ethylbenzene, amylbenzene, isopropylbenzene, hexane, heptane, octane, nonane, decane, dodecane, cyclohexane, methylcyclohexane, p-menthane, decalin, xylene, cyclohexylbenzene, cyclohexene, cyclopentane, dipentene, naphthalene, dimethylnaphthalene, cymene, tetralin, biphenyl, mesitylene, etc.;

- Halogenated hydrocarbon solvents, e.g., methylene chloride, hexyl chloride, chlorobenzene, bromobenzene, etc.;
- Alcohols, e.g., amyl alcohol, isoamyl alcohol, butanol, hexanol, 3-heptanol, i-butyl alcohol, 2-ethylbutanol, 2-ethylhexanol, octanol, nonanol, neopentyl alcohol, cyclohexanol, tetrahydrofurfuryl alcohol, etc.;
- Nitrogen-containing solvents, e.g., acetonitrile, isopropanolamine, ethylhexylamine, N-ethylmorpholine, diisopropylamine, cyclohexylamine, di-n-butylamine, tetramethylethylenediamine, tripropylamine, etc.;
- Carboxylic acid solvents, e.g., formic acid, acetic acid, butyric acid, isobutyric acid, itaconic acid, propionic acid, etc.;
- Acid anhydride solvents, e.g., acetic anhydride, propionic anhydride, itaconic anhydride, etc.;
- Fluorine solvents, e.g., 1,4-difluorobenzene, 1,1,2,2- tetrachlorodifluoroethane, tetrafluoropropanol, ethyl trifluoroacetoacetate, perfluoroheptane, hexafluoro- isopropanol, perfluorobutylethanol, pentafluoropropanol, hexafluorobenzene, perfluorobutyltetrahydrofuran, perfluoropolyethers, fluorophenols, etc.; and
- Other solvents, e.g., anisole, dioxane, dioxolan, dibutyl ether, ethyl-n-butyl ketone, diacetone alcohol, diisobutyl ketone, methyl isobutyl ketone, methyl-n-butyl ketone, ethylene glycol, diglycidyl ether, ethylene dichloride, cyclohexanone, cyclopentanone, 2-heptanone, γ-butyrolactone, methyl ethyl ketone, ethylene glycol, ethylene glycol monomethyl ether, ethylene glycol monoethyl ether, 2-methoxyethyl acetate, ethylene glycol monoethyl ether acetate; propylene glycol, propylene glycol monomethyl ether, propylene glycol monomethyl ether acetate, toluene, ethyl acetate, methyl lactate, ethyl lactate, methyl methoxy- propionate, ethyl ethoxypropionate, methyl pyruvate, ethyl pyruvate, propyl pyruvate, N,N-dimethylformamide, dimethyl sulfoxide, N-methylpyrrolidone, methoxybutanol, tetrahydro- furan, ethylethoxy propionate, butyl acetate, and N,N-dimethylacetamide.

It is preferred to use mixed solvent (Y') in a protective film-forming composition for immersion exposure in the invention.

The coating property of the composition can be improved by using a mixed solvent.

The mixed solvents are not particularly restricted but the solvents obtained by adding polar solvents, e.g., alcohol solvents, ether solvents, nitrogen-containing solvents, carboxylic acid solvents, acid anhydride solvents, ester solvents, or ketone solvents to non-polar solvents, e.g., hydrocarbon solvents, halogenated hydrocarbon solvents, or fluorine-containing non-polar solvents are preferred.

As the non-polar solvents for use in mixed solvent (Y'), the following solvents are exemplified.

- Hydrocarbon solvents, e.g., benzene, toluene, ethylbenzene, amylbenzene, isopropylbenzene, hexane, heptane, octane, nonane, decane, dodecane, cyclohexane, methylcyclohexane, p-menthane, decalin, xylene, cyclohexylbenzene, cyclohexene, cyclopentane, dipentene, naphthalene, dimethylnaphthalene, cymene, tetralin, biphenyl, mesitylene, etc.;

- Halogenated hydrocarbon solvents, e.g., chloroform, hexyl chloride, ethylene dichloride, chlorobenzene, bromobenzene, iodobenzene, etc.; and
- Fluorine-containing non-polar solvents, e.g., 1,4- difluorobenzene, 1,1,2,2-tetrachlorodifluoroethane, perfluoroheptane, hexafluorobenzene, perfluorobutyltetrahydrofuran, etc.

As the polar solvents for use in mixed solvent (Y'), the following solvents are exemplified.

Alcohol solvents, e.g., amyl alcohol, isoamyl alcohol, butanol, hexanol, 3-heptanol, i-butyl alcohol, 2-ethylbutanol, 2-ethylhexanol, octanol, nonanol, neopentyl alcohol, cyclohexanol, tetrahydrofurfuryl alcohol, ethylene glycol, propylene glycol, tetrafluoropropanol, hexafluoroisopropanol, perfluorobutylethanol, pentafluoropropanol, fluorophenols, etc.; Ether solvents, e.g., anisole, dioxane, dioxolan, dibutyl ether, tetrahydrofuran, etc.;
Nitrogen-containing solvents, e.g., acetonitrile, isopropanolamine, ethylhexylamine, N-ethylmorpholine, diisopropylamine, cyclohexylamine, di-n-butylamine, tetramethylethylenediamine, tripropylamine, etc.;
Carboxylic acid solvents, e.g., formic acid, acetic acid, butyric acid, isobutyric acid, itaconic acid, propionic acid, etc.;
• Acid anhydride solvents, e.g., acetic anhydride, propionic anhydride, itaconic anhydride, etc.;
• Ester solvents, e.g., ethyl acetate, butyl acetate, methyl lactate, ethyl lactate, methyl methoxypropionate, ethyl ethoxypropionate, methyl pyruvate, ethyl pyruvate, propyl pyruvate, $\gamma$-butyrolactone, etc.;
Ketone solvents, e.g., ethyl-n-butyl ketone, diisobutyl ketone, methyl isobutyl ketone, methyl-n-butyl ketone, cyclohexanone, cyclopentanone, 2-heptanone, methyl ethyl ketone, etc.; and
Other polar solvents, e.g., ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, N,N-dimethylformamide, dimethyl sulfoxide, N-methyl- pyrrolidone, methoxybutanol, ethylethoxy propionate, and N,N-dimethylacetamide.

The combination of a polar solvent and a non-polar solvent is not particularly restricted, but the combinations of using hydrocarbon solvents or fluorine-containing non-polar solvents as the non-polar solvent and using alcohol solvents as the polar solvent are preferred.
The mixing ratio is preferably non-polar solvent/polar solvent of from 95/5 to 40/60 by mass, more preferably from 90/10 to 50/50, and still more preferably from 85/15 to 60/40.

<u>(3) Surfactant (Z)</u>

The protective film-forming composition for immersion exposure in the invention can further contain surfactant (Z). It is preferred to contain either one or two or more of fluorine and/or silicon surfactants (a fluorine surfactant, a silicon surfactant, a surfactant containing both a fluorine atom and a silicon atom) as surfactant (Z). By containing surfactant (Z), it is possible to provide a resist pattern excellent in coating property and adhesion, and little in development failure, with good sensitivity and resolution in the time of using an exposure light source of 250 nm or lower, particularly 220 nm or lower.
As the fluorine and/or silicon surfactants, the surfactants disclosed, e.g., in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862, U.S. Patents 5,405,720, 5,360,692, 5,529,881, 5,296,330, 5,436,098, 5,576,143, 5,294,511 and 5,824,451 are exemplified. The following commercially available surfactants can also be used as they are.
As the fluorine or silicon surfactants usable in the invention, Eftop EF301 and EF303 (manufactured by Shin-Akita Kasei Co., Ltd.), Fluorad FC 430 and 431 (manufactured by Sumitomo 3M Limited), Megafac F171, F173, F176, F189 and R08 (manufactured by Dainippon Ink and Chemicals Inc.), Sarfron S-382, SC101, 102, 103, 104, 105 and 106 (manufactured by ASAHI GLASS CO., LTD.), and Troy Sol S-366 (manufactured by Troy Chemical Co., Ltd.) are exemplified. Further, polysiloxane polymer KP-341 (manufactured by Shin-Etsu Chemical Co., Ltd.) can also be used as a silicon surfactant.
As surfactants, in addition to the above-shown well- known surfactants, surfactants using polymers having fluoro- aliphatic groups derived from fluoro-aliphatic compounds manufactured by a telomerization method (also called a telomer method) or an oligomerization method (also called an oligomer method) can be used. Fluoro-aliphatic compounds can be synthesized by the method disclosed in JP-A-2002-90991.
As polymers having fluoro-aliphatic groups, copolymers of monomers having fluoro-aliphatic groups and (poly(oxy-alkylene)) acrylate and/or (poly(oxyalkylene)) methacrylate are preferred, and these copolymers may be irregularly distributed or may be block copolymerized. As the poly(oxy- alkylene) groups, a poly(oxyethylene) group, a poly(oxypropylene) group and poly(oxybutylene) group are exemplified. In addition, the polymers may be units having alkylene different in a chain length in the same chain length, such as a block combination of poly(oxyethylene and oxypropylene and oxyethylene), and a block combination of poly(oxyethylene and oxypropylene). Further, copolymers of monomers

having fluoro-aliphatic groups and poly(oxyalkylene) acrylate (or methacrylate) may be not only bipolymers but also terpolymers or higher copolymers obtained by copolymerization of monomers having different two or more kinds of fluoro- aliphatic groups or different two or more kinds of poly- (oxyalkylene) acrylates (or methacrylates) at the same time.

For example, as commercially available surfactants, Megafac F-178, F-470, F-473, F-475, F-476 and F-472 (manufactured by Dainippon Ink and Chemicals Inc.) can be exemplified. Further, copolymers of acrylate (or methacrylate) having a $C_6F_{13}$ group and (poly(oxyalkylene)) acrylate (or methacrylate), copolymers of acrylate (or methacrylate) having a $C_6F_{13}$ group, (poly(oxyethylene)) acrylate (or methacrylate), and (poly-(oxypropylene)) acrylate (or methacrylate), copolymers of acrylate (or methacrylate) having a $C_8F_{17}$ group and (poly- (oxyalkylene)) acrylate (or methacrylate), copolymers of acrylate (or methacrylate) having a $C_8F_{17}$ group, (poly(oxy- ethylene)) acrylate (or methacrylate), and poly(oxypropylene) acrylate (or methacrylate) are exemplified.

In the invention, surfactants other than fluorine and/or silicon surfactants can also be used. Specifically, nonionic surfactants, such as polyoxyethylene alkyl ethers, e.g., polyoxyethylene lauryl ether, polyoxyethylene stearyl ether, polyoxyethylene cetyl ether, and polyoxyethylene oleyl ether, polyoxyethylene alkylallyl ether, e.g., polyoxyethylene octylphenol ether and polyoxyethylene nonylphenol ether, polyoxyethylene-polyoxypropylene block copolymers, sorbitan fatty acid esters, e.g., sorbitan monolaurate, sorbitan monopalinitate, sorbitan monostearate, sorbitan monooleate, sorbitan trioleate, and sorbitan tristearate, and polyoxy- ethylene sorbitan fatty acid esters, e.g., polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate can be exemplified.

These surfactants may be used alone or some kinds may be used in combination.

The use amount of surfactants (Z) is preferably from 0.0001 to 2 mass% to the total amount of the protective film-forming composition for immersion exposure (excluding solvents), more preferably from 0.001 to 1 mass%.

(4) Protective film

The protective film-forming composition for immersion exposure in the invention is formed on a resist film by, e.g., coating, to form a protective film for the purpose of prevention of the osmosis of an immersion liquid into the resist film and the elution of the resist components to the immersion liquid. The coating means is not particularly restricted and optionally selected according to the process applied, e.g., a means of spin coating can be used.

From the viewpoint that a protective film is preferably transparent to the exposure light source, a thinner film is preferred and generally the thickness is from 1 to 300 nm, preferably from 10 to 150 nm. Specifically, the thickness of a film is such that the transmission of the exposure light of a film becomes preferably from 50 to 80%, more preferably from 60 to 70%. The transmission of exposure light can be adjusted by adjusting the polymerization components of a resin. For example, the transmission of ArF light can be increased by the decrease of the amount of aromatic rings contained in a resin.

Further, for preventing an immersion liquid and lens from being contaminated by the eluate from a protective film, it is preferred that there is no eluate from a protective film. For the purpose of preventing the eluate, the content of a low molecular weight compound (e.g., a compound having a molecular weight of 1,000 or less) in a protective film is preferably less.

From the viewpoint of the affinity with an immersion liquid, the contact angle (at 23°C) of an immersion liquid to a protective film is preferably from 50 to 80°, more preferably from 60 to 80°. The contact angle can be adjusted to the above range by the adjustment of the amount of acid groups or by controlling the hydrophilic-hydrophobic property of the copolymer components.

The refractive index of a protective film is preferably close to the refractive index of a resist film from the viewpoint of resolution. The adjustment of the refractive index can be carried out by the control of the components of a protective film-forming composition, particularly the resin composition, and the ratio of repeating units.

Protective film-forming compositions capable of being uniformly coated in forming a protective film are preferably used. A coating property (coating uniformity) can be improved by the selection of the kinds of solvents, surfactants and other additives and the adjustment of the addition amounts of these compounds.

It is preferred for the resist pattern formed not to have electric conductivity and, at the same time, a protective film-forming composition for immersion exposure does not contain metals. The amount of metals contained in a protective film-forming composition is preferably 100 ppb or less, more preferably 50 ppb or less. The amount of metals can be controlled by general purification, e.g., the improvement of the purity of materials used and by filtration.

A protective film-forming composition for immersion exposure is coated on a resist film to thereby form a protective film, so that it is preferably a composition that does not admix with a resist film.

(5) Pattern-forming method

The above components of the protective film-forming composition for immersion exposure in the invention are

generally dissolved with a solvent and coated on a resist film on a substrate.

That is, a resist composition for immersion exposure is coated on such a substrate as is used in the manufacture of a precision integrated circuit element by a proper coating method (e.g., by a spinner or a coater) in an optional thickness (generally from 50 to 500 nm). At this time, it is also preferred to provide an appropriate reflection preventing film on a substrate and then form a resist film thereon. After coating, the coated film is dried by spin or baking, thereby a resist film is formed.

Further, similarly to the resist composition, a protective film-forming composition for immersion exposure is coated on the resist film with a spinner or a coater, dried by spin or baking to form a protective film.

Subsequently, the resist film is subjected to exposure through a mask via an immersion liquid (immersion exposure) for pattern forming.

The quantity of exposure can be arbitrarily set but generally the quantity is from 1 to 100 $mJ/cm^2$. After exposure, preferably spin or/and baking are carried out, followed by development and rinsing, thereby a pattern is obtained. In the invention, a protective film is dissolved in a developing solution during a development process and peeled off, so that a special peeling process need not be provided.

It is preferred to perform baking after exposure, and the temperature of baking is generally from 30 to 300°C. From the viewpoint of the prevention of the change of the line width of resist pattern due to the fluctuation of post exposure time delay (PED) from the exposure to development process, the time from exposure to baking process is preferably shorter.

As exposure light, far ultraviolet rays of preferably 250 nm or less, more preferably 220 nm or less, are used. Specifically, a KrF excimer laser (248 nm), an ArF excimer laser (193 nm), an $F_2$ excimer laser (157 nm), and an X-ray are exemplified.

As the substrates that can be used, a generally used Bare Si substrate, an SOG substrate or a substrate with a reflection preventing film can be exemplified.

As the reflection preventing films, inorganic film type reflection preventing films, e.g., titanium, titanium dioxide, titanium nitride, chromium oxide, carbon and $\alpha$-silicon, and organic film type films, e.g., films comprising light absorbers and polymer materials can be used. The former necessitates equipments such as a vacuum evaporation apparatus, a CVD apparatus, or a sputtering apparatus in film forming. As the organic reflection preventing films, e.g., those comprising condensation products of diphenylamine derivatives and formaldehyde-modified melamine resins, alkali-soluble resins and light absorbers as disclosed in JP-B-7-69611, reaction products of maleic anhydride copolymers and diamine-type light absorbers as disclosed in U.S. Patent 5,294,680, those containing resin binders and methylolmelamine series thermal crosslinking agents as disclosed in JP-A-6-118631, acrylic resin type reflection preventing films having a carboxylic acid group, an epoxy group and a light-absorbing group in the same molecule as disclosed in JP-A-6-118656, those comprising methylolmelamine and benzophenone light absorbers as disclosed in JP-A-8-7115, and those obtained by adding low molecular weight light absorbers to polyvinyl alcohol resins as disclosed in JP-A-8-179509 are exemplified.

As the organic reflection preventing films, DUV-30 series, DUV-40 series and ARC25 manufactured by Brewer Science, and AC-2, AC-3, AR19 and AR20 manufactured by Shipley Co. can also be used.

An immersion liquid for use in immersion exposure is described below.

An immersion liquid for use in immersion exposure preferably has a temperature coefficient of refractive index as small as possible so as to be transparent to the exposure wavelength and to hold the distortion of an optical image reflected on a resist to the minimum. In particular, when the exposure light source is an ArF excimer laser (wavelength: 193 nm), it is preferred to use water as the immersion liquid for easiness of availability and an easy handling property, in addition to the above points of view.

When water is used as the immersion liquid, to reduce the surface tension of water and to increase the surface activity, a trace amount of additive (a liquid) that does not dissolve the resist layer on a wafer and has a negligible influence on the optical coating of the lower surface of a lens may be added. As such additives, aliphatic alcohols having a refractive index almost equal to the refractive index of water are preferred, specifically methyl alcohol, ethyl alcohol and isopropyl alcohol are exemplified. By adding an alcohol having a refractive index almost equal to that of water, even if the alcohol component in water is evaporated and the concentration of the content is changed, the refractive index change of the liquid as a whole can be made extremely small. On the other hand, when substances opaque to the light of 193 nm or impurities largely different from water in refractive index are mixed, these substances or impurities bring about the distortion of the optical image reflected on the resist. Accordingly the water used is preferably distilled water. Further, pure water filtered through an ion exchange filter may be used.

The electric resistance of water is preferably 18.3 M $\Omega$·cm or higher, and TOC (concentration of organic substance) is preferably 20 ppb or lower. Further, it is preferred that water has been subjected to deaeration treatment.

As the alkali developer for use in a development process, alkaline aqueous solutions of inorganic alkalis, e.g., sodium hydroxide, potassium hydroxide, sodium carbonate, sodium silicate, sodium metasilicate and aqueous ammonia, primary amines, e.g., ethylamine and n-propylamine, secondary amines, e.g., diethylamine and di-n-butylamine, tertiary amines, e.g., triethylamine and methyldiethylamine, alcohol amines, e.g., dimethylethanolamine and triethanol- amine,

quaternary ammonium salts, e.g., tetramethylammonium hydroxide and tetraethylammonium hydroxide, and cyclic amines, e.g., pyrrole and piperidine, can be used.

An appropriate amount of alcohols and surfactants may be added to the alkaline aqueous solutions.

The alkali concentration of the alkali developers is generally from 0.1 to 20 mass%.

The pH of the alkali developers is generally from 10.0 to 15.0.

Pure water is used as a rinsing liquid, and an appropriate amount of surfactants may be added to pure water.

After development process or rinsing process, a process to remove the developing solution or the rinsing liquid on the resist pattern can be performed by supercritical fluid.

In the immersion exposure using a protective film in the invention, resists are not particularly restricted and they can be arbitrarily selected from among the resists generally used, and any of positive and negative resists can be used.

Positive resists and negative resists sufficiently provided with various requisites applicable to the latest superfine process are preferably used, and chemical amplification-type resists and positive resists are particularly preferably used in the invention.

As the chemical amplification-type resists, so-called acid generators capable of generating acid by active energy rays, e.g., light, are typically exemplified in the invention. For example, as negative chemical amplification type resists, three-component series resists comprising a base polymer, a light-acid generator and a crosslinking agent are used, and in the time of resist exposure, the acid generated on the exposed area upon irradiation with light brings about a crosslinking reaction and functions to the resist to lower the solubility in a developing solution. On the other hand, as positive chemical amplification type resists, there are generally two-component series resists comprising a base polymer having a site blocked with a protective group having a dissolution-inhibiting function and a light-acid generator, and three-component series resists comprising a base polymer, an acid generator and a dissolution-inhibiting agent, and in the time of resist exposure, the acid generated on the exposed area upon irradiation with light functions to detach the protective group of the polymer to increase the solubility in a developing solution.

When the exposure light source is an ArF excimer laser (wavelength: 193 nm), two-component resists comprising a resin capable of increasing the solubility in an alkali developer by the action of an acid, and a light-acid generator are preferably used.

In particular, the resin capable of increasing the solubility in an alkali developer by the action of an acid is preferably an acrylic or methacrylic resin having a monocyclic or polycyclic alicyclic hydrocarbon structure, the resin having a lactone residue or an adamantane residue is more preferred.

Since it is preferred for the resist pattern formed not to have electric conductivity, a resist preferably does not contain metals. The amount of metals contained is preferably 100 ppb or less, more preferably 50 ppb or less. The amount of metals can be controlled by general purification, e.g., the improvement of the purity of materials used and by filtration.

## EXAMPLE

The invention is described in further detail with referring to the examples but the invention is not limited thereto.

### Synthesis of Resin (1):

4-[Bis(trifluoromethyl)hydroxymethyl]styrene (8. 11. g) (0.03 mol) and 10.93 g (0.07 mol) of tetrahydro-5-oxofuran-3-yl acrylate were dissolved in 250 ml of propylene glycol monomethyl ether, and 0.25 g of 2,2'-azobis(2,4-dimethylvaleronitrile) (V-65, trade name, manufactured by Wako Pure Chemical Industries) was added thereto as a polymerization initiator. The solution was stirred at 70°C for 4 hours under nitrogen current. Thereafter, the reaction solution was put into 1 liter of hexane with vigorously stirring. The resin precipitated was washed with ion exchange water, filtered, and dried under vacuum, thereby 15 g of a white resin was obtained. The weight average molecular weight (in terms of polystyrene) was confirmed to be 5,800 and the percentage of residual monomer in the resin was 1 mass% or less from GPC measurement.

Resins (1) to (9), Comparative Resin 1 and Comparative Resin 2 were synthesized in the same manner as above.

The structural formula, weight average molecular weight, degree of dispersion and percentage of residual monomer of each of Resins (1) to (9), Comparative Resin 1 and Comparative Resin 2 are collectively shown below.

(1) 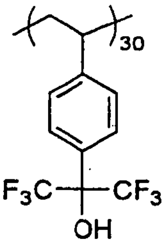 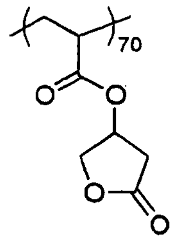

Mw= 5800
Mw/Mn= 2.53
Residual monomer: 1%

(2) 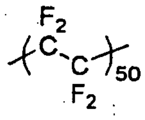 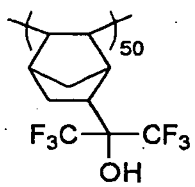

Mw= 5400
Mw/Mn= 2.15
Residual monomer: 2%

(3) 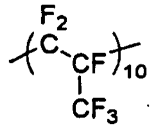 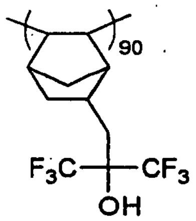

Mw= 4800
Mw/Mn= 2.45
Residual monomer: 4%

(4) 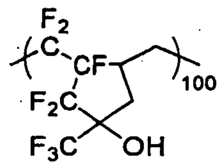

Mw= 6100
Mw/Mn= 2.38
Residual monomer: 3%

(5) 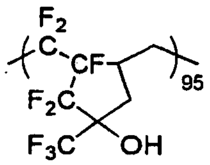 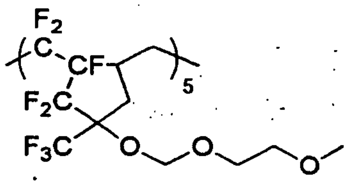

Mw= 6300
Mw/Mn= 2.37
Residual monomer: 2%

(6) 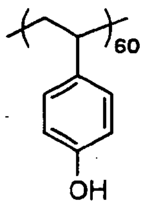 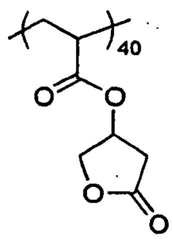

Mw= 8700
Mw/Mn= 2.44
Residual monomer: 3%

(7) 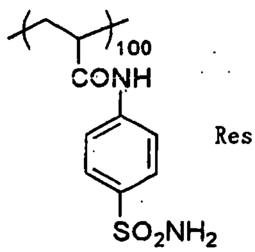

Mw= 10800
Mw/Mn= 2.32
Residual monomer: 0%

(8) 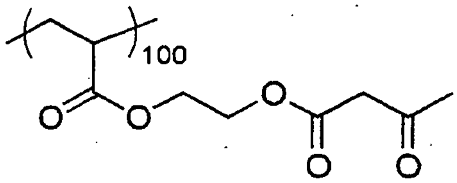

Mw= 6500
Mw/Mn= 2.41
Residual monomer: 0%

(9) 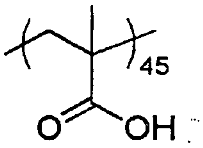 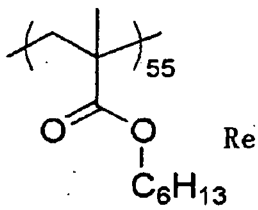

Mw= 7400
Mw/Mn= 2.38
Residual monomer: 1%

(Comparative Resin 1) 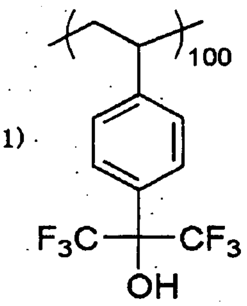

Mw= 10200
Mw/Mn= 2.44
Residual monomer: 1%

(Comparative Resin 2) 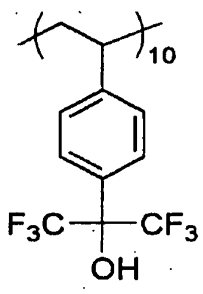 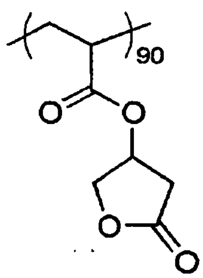

Mw= 6200
Mw/Mn= 2.42
Residual monomer: 2%

Manufacture of protective film-forming composition for immersion exposure:

The components shown in Table 1 below were respectively dissolved in a solvent to prepare solutions having solid content concentration of 6 mass%, and the solutions were filtered through a polyethylene filter having a pore diameter of 0.1 μm, thereby protective film-forming compositions (TC-1) to (TC-11) for immersion exposure were prepared.

TABLE 1

| Protective Film-Forming Composition for Immersion Exposure | Resin (2 g) | Solvent (mass%) | Surfactant (5 mg) |
|---|---|---|---|
| TC-1 | (1) | SL-2 (100) | None |
| TC-2 | (2) | SL-2 (100) | W-1 |
| TC-3 | (3) | SL-1 (40)<br>SL-2 (60) | W-1 |
| TC-4 | (4) | SL-1 (40)<br>SL-2 (60) | W-1 |

(continued)

| Protective Film-Forming Composition for Immersion Exposure | Resin (2 g) | Solvent (mass%) | Surfactant (5 mg) |
|---|---|---|---|
| TC-5 | (5) | SL-2 (100) | W-2 |
| TC-6 | (6) | SL-1 (100) | W-1 |
| TC-7 | (7) | SL-1 (100) | W-1 |
| TC-8 | (8) | SL-1 (30) SL-2 (70) | W-2 |
| TC-9 | (9) | SL-1 (100) | W-1 |
| TC-10 | Comparative Resin 1 | SL-1 (100) | None |
| TC-11 | Comparative Resin 2 | SL-1 (100) | None |

The abbreviations in Table 1 are as follows.

W-1: Megafac F176 (fluorine surfactant, manufactured by Dainippon Ink and Chemicals Inc.)
W-2: Megafac R08 (fluorine and silicon surfactant, manufactured by Dainippon Ink and Chemicals Inc.)
SL-1: Propylene glycol dimethyl ether
SL-2: Perfluorobutyltetrahydrofuran

EXAMPLES 1 TO 36 AND COMPARATIVE EXAMPLES 1 TO 8

Measurement of dissolution rate of protective film in an alkali developer:

Each of the protective film-forming compositions for immersion exposure shown in Table 2 below was coated by spin coating on a 4-inch silicon wafer having been subjected to dehydration treatment with hexamethyldisilazane, and the coating solvent was heated and dried on a hot plate at 115°C for 60 seconds to thereby form a protective film. The dissolution rate of the protective film in a 2.38 mass% aqueous solution of tetramethylammonium (an alkali developer) at 23°C was analyzed with a resist dissolution rate analyzer (RDA 790, manufactured by Litho Tech Japan Co., Ltd.). The results obtained are shown in Table 2 below.

Evaluation of swelling of protective film in immersion liquid (water):

Each of the protective film-forming compositions for immersion exposure shown in Table 2 was coated by spin coating on a 4-inch silicon wafer having been subjected to dehydration treatment with hexamethyldisilazane, and the coating solvent was heated and dried on a hot plate at 115°C for 60 seconds to thereby form a protective film. The protective film was soaked in pure water at 23°C for 10 minutes and dried. The thickness of the protective film was measured after drying and the degree of increase in thickness (swelling) was evaluated by comparing with the thickness just after coating. The results obtained are shown in Table 2.

Evaluation of sectional form of resist pattern:

An organic reflection preventing film ARC29A (manufactured by Nissan Chemical Industries Ltd.) was coated on a silicon wafer by spin coating and baked at 205°C for 60 seconds, and a reflection preventing film having a thickness of 78 nm was formed. Each resist composition shown in Table 2 below was coated on the reflection preventing film and baked at 115°C for 60 seconds, thereby a resist film having a thickness of 200 nm was formed. Further, the protective film-forming composition for immersion exposure shown in Table 2 was coated on the resist film and baked at 90°C for 60 seconds, thus a protective film having a thickness of 50 nm was formed.

By using water as the immersion liquid, each of the thus obtained wafers was subjected to two-beam interference exposure with the apparatus shown in Fig. 1. In the apparatus shown in Fig. 1, 1 is a laser, 2 is a diaphragm, 3 is a shutter, 4, 5 and 6 are reflection mirrors, 7 is a condenser lens, 8 is a prism, 9 is an immersion liquid, 10 is a wafer provided with a reflection preventing film and a resist film, and 11 is a wafer stage. The output wavelength of 193 nm was used as laser 1. After exposure, each wafer was baked at 115°C for 60 seconds, and then subjected to development with an aqueous solution of tetramethylammonium hydroxide (2.38 mass%) for 60 minutes, rinsing with pure water, and

drying by spinning, thereby a resist pattern was obtained.

As prism 8 of the two-beam interference exposure apparatus, a prism for forming a 90 nm line-and-space pattern was used. The sectional form of the resist pattern after exposure was observed with a scanning electron microscope (S-4300, manufactured by Hitachi Limited), and the results of evaluation are shown in Table 2. In the signs of the sectional form of resist pattern in Table 2, the one having a rectangular form is graded A, the one with a little eaves is graded B, the one with a considerable eaves and showing pattern collapse is graded C, and the one with a round top is graded D.

TABLE 2

| Example No. | Protective Film-Forming Composition for Immersion Exposure | Dissolution Rate of Protective Film in Alkali Developing Solution (nm/sec) | Swelling in Water of ProtectiveFilm (nm) | Resist Composition | Sectional Form of Resist Pattern |
|---|---|---|---|---|---|
| Example 1 | TC-1 | 190 | 2.5 | PR-1 | D |
| Example 2 | TC-1 | 190 | 2.5 | PR-2 | A |
| Example 3 | TC-1 | 190 | 2.5 | PR-3 | A |
| Example 4 | TC-1 | 190 | 2.5 | PR-4 | A |
| Example 5 | TC-2 | 85 | 0.1 | PR-1 | A’ |
| Example 6 | TC-2 | 85 | 0.1 | PR-2 | A |
| Example 7 | TC-2 | 85 | 0.1 | PR-3 | A |
| Example 8 | TC-2 | 85 | 0.1 | PR-4 | A |
| Example 9 | TC-3 | 130 | 1.5 | PR-1 | D |
| Example 10 | TC-3 | 130 | 1.5 | PR-2 | A |
| Example 11 | TC-3 | 130 | 1.5 | PR-3 | A |
| Example 12 | TC-3 | 130 | 1.5 | PR-4 | A |
| Example 13 | TC-4 | 35 | 0.1 | PR-1 | A |
| Example 14 | TC-4 | 35 | 0.1 | PR-2 | A |
| Example 15 | TC-4 | 35 | 0.1 | PR-3 | A |
| Example 16 | TC-4 | 35 | 0.1 | PR-4 | A |
| Example 17 | TC-5 | 22 | 0.1 | PR-1 | B |
| Example 18 | TC-5 | 22 | 0.1 | PR-2 | B |
| Example 19 | TC-5 | 22 | 0.1 | PR-3 | A |
| Example 20 | TC-5 | 22 | 0.1 | PR-4 | A |
| Example 21 | TC-6 | 100 | 2.5 | PR-1 | A |
| Example 22 | TC-6 | 100 | 2.5 | PR-2 | D |
| Example 23 | TC-6 | 100 | 2.5 | PR-3 | A |
| Example 24 | TC-6 | 100 | 2.5 | PR-4 | A |
| Example 25 | TC-7 | 220 | 3.2 | PR-1 | A |
| Example 26 | TC-7 | 220 | 3.2 | PR-2 | D |
| Example 27 | TC-7 | 220 | 3.2 | PR-3 | A |
| Example 28 | TC-7 | 220 | 3.2 | PR-4 | A |

(continued)

| Example No. | Protective Film-Forming Composition for Immersion Exposure | Dissolution Rate of Protective Film in Alkali Developing Solution (nm/sec) | Swelling in Water of ProtectiveFilm (nm) | Resist Composition | Sectional Form of Resist Pattern |
|---|---|---|---|---|---|
| Example 29 | TC-8 | 26 | 0.3 | PR-1 | A |
| Example 30 | | | | PR-2 | A |
| Example 31 | | | | PR-3 | B |
| Example 32 | | | | PR-4 | B |
| Example 33 | TC-9 | 280 | 3.5 | PR-1 | D |
| Example 34 | | | | PR-2 | D |
| Example 35 | | | | PR-3 | A |
| Example 36 | | | | PR-4 | A |
| Comparative Example 1 | TC-10 | 600 | 10.8 | PR-1 | D |
| Comparative Example 2 | | | | PR-2 | D |
| Comparative Example 3 | | | | PR-3 | D |
| Comparative Example 4 | | | | PR-4 | D |
| Comparative Example 5 | TC-11 | 10 | 0.1 | PR-1 | C |
| Comparative Example 6 | | | | PR-2 | C |
| Comparative Example 7 | | | | PR-3 | C |
| Comparative Example 8 | | | | PR-4 | C |

The abbreviations in Table 2 are as follows.

PR-1:

A resist composition described in Example 1 in JP-A-2000- 275845, that is, a resist composition comprising 10 mass parts of resin P-1 shown below (weight average molecular weight: about 10,000), 0.2 mass parts of an acid generator (triphenylsulfonium perfluorobutanesulfonate (TPS-109, manufactured by Midori Chemical Co., Ltd.)), 0.015 mass parts of a basic compound (2,6-diisopropylaniline), and solvents (47.5 mass parts of propylene glycol monomethyl ether acetate and 2.5 mass parts of $\gamma$-butyrolactone).

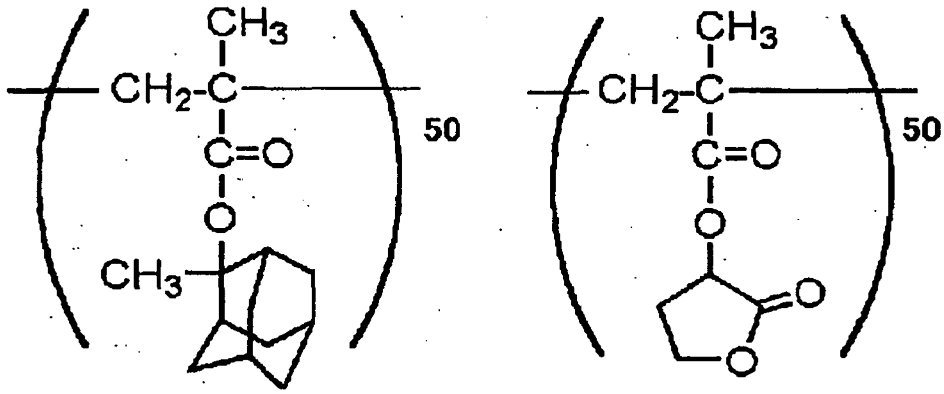

(P-1)

PR-2:

A resist composition described in Example 1 in JP-A-2003- 167347, that is, a resist composition comprising 100 mass parts of resin P-2 shown below (weight average molecular weight: 10,000), 2 mass parts of an acid generator (triphenylsulfonium nonafluorobutanesulfonate), 0.2 mass parts of a basic compound (triethanolamine), and organic solvents (750 mass parts of propylene glycol monomethyl ether acetate and 30 mass parts of γ-butyrolactone).

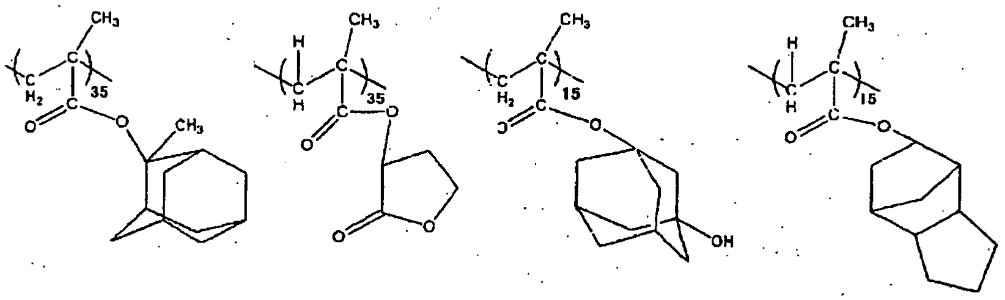

(P-2)

PR-3 :

A resist composition described in Example 1 in JP-A-2002- 12622, that is, a resist composition comprising 80 mass parts of resin P-3 shown below, 1 mass part of an acid generator (PAG1), 0.078 mass parts of a basic compound (TBA: tributylamine), and 480 mass parts of solvents (PGMEA: propylene glycol methyl ether acetate).

(P-3)

(x=0.50, e=0.50, Mw=12,200)

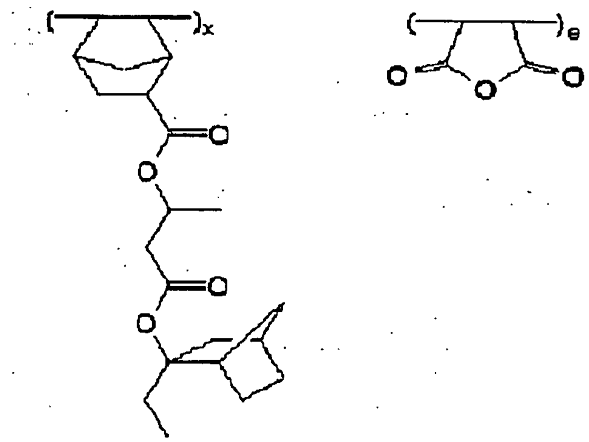

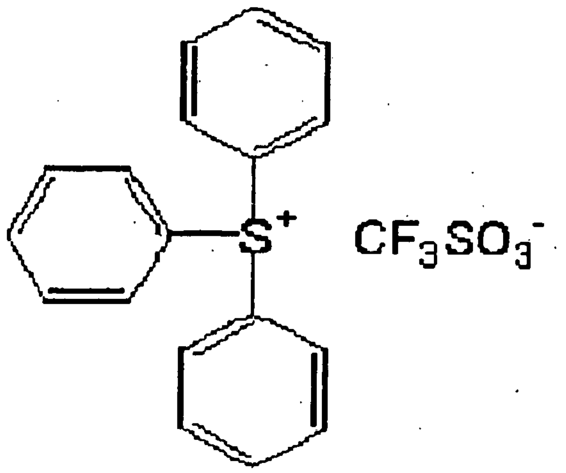

(PAG 1)

PR-4:

A resist composition described in Example 1 in JP-A-2003- 177538, that is, a resist composition comprising 2 g of resin P-4 shown below (weight average molecular weight: 10,600), 38 mg of an acid generator (PAG2), 4 mg of a basic compound (1,5-diazabicyclo[4.3.0]-5-nonene (DBN)), 10 g of a surfactant (Megafac F176, manufactured by Dainippon Ink and Chemicals Inc.), and solvents (propylene glycol methyl ether acetate (PGMEA)/ethyl lactate = 70/30, solid concentration: 14 wt%).

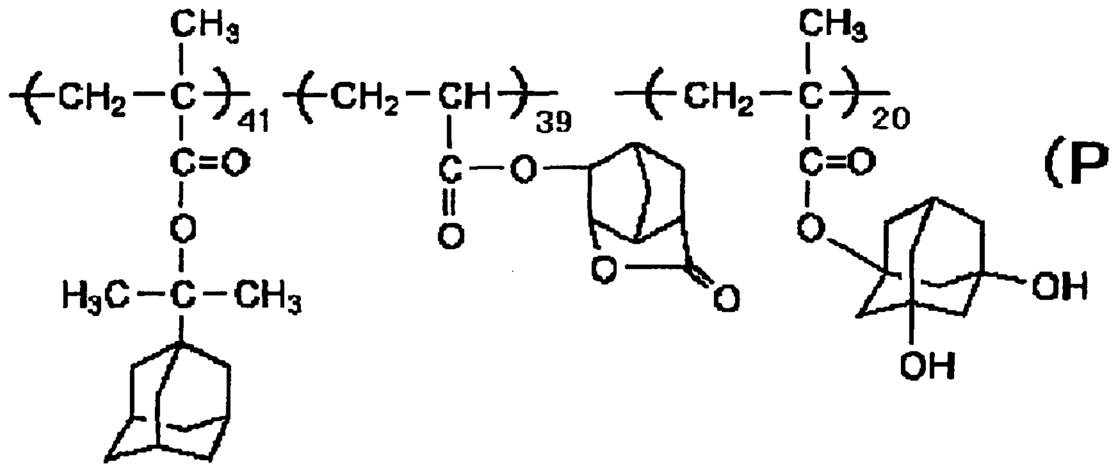

(P-4)

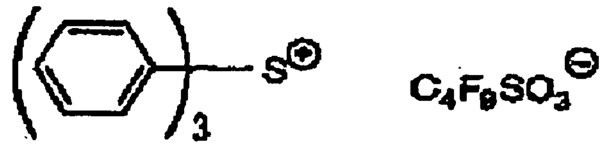

(PAG 2)

As is apparent from the results shown in Table 2, the protective film-forming compositions for immersion exposure in the invention are swelling in water is extremely small when pure water is used as the immersion liquid. Also as shown in Table 2, resist patterns having a rectangular form can be obtained by using the protective film-forming compositions for immersion exposure in the invention, but when the protective film-forming compositions for immersion exposure other than the compositions in the invention are used, strong eaves and pattern collapse are observed on the obtained resist patterns, or the resist patterns become round top.

By the protective film- forming method and pattern- forming method provided by the invention, it becomes possible to prevent the osmosis of an immersion liquid into the inside of a resist film, particularly the osmosis of water in ArF immersion lithography, and the elution of resist film components into an immersion liquid without complicating the process at the time of immersion exposure.

## Claims

1. Method of forming a protective film having a dry film dissolution rate in an alkali developer of 20-300 nm/sec for immersion exposure comprising the steps of
coating a composition comprising a water-insoluble resin (X) on a substrate and
drying the composition,
wherein the water-insoluble resin (X)
has a residual monomer amount of 5 mass% or less with respect to the water-insoluble resin (X) and
contains at least one repeating unit selected from
repeating unit (X-1) derived from a monomer having a pKa of less than 8, and
repeating unit (X-2) derived from a monomer having a pKa of 8 or more, wherein
when the water-insoluble resin (X) contains repeating unit (X-1), the acid value (milli-equivalent/g) of the water-insoluble resin (X) is from 1.0-5.0 and
when the water-insoluble resin (X) contains repeating unit (X-2), the acid value (milli-equivalent/g) of the water-insoluble resin (X) is from 3.0-7.0 and
when the water-insoluble resin (X) contains both repeating unit (X-1) and repeating unit (X-2), the acid value (milli-equivalent/g) of the water-insoluble resin (X) is from 2.0-5.0.

2. The method of claim 1, wherein the monomer having a pKa of less than 8 is a monomer containing an acid group which is selected from carboxylic acids, ammonium salts and pyridinium salts.

3. The method of claim 1 or 2, wherein the monomer having a pKa of 8 or more is a monomer containing an acid group which is selected from a phenolic hydroxyl group, a sulfonamide group, $-COCH_2CO-$, and a fluoro-alcohol group.

4. The method of any one of claims 1-3, wherein the dissolution rate in an alkali developer is from 25-200 nm/sec.

5. The method of any one of claims 1-4, wherein the dissolution rate in an alkali developer is from 30-90 nm/sec.

6. The method of any one of claims 1-5, wherein the composition comprises a surfactant (Z).

7. The method of any one of claims 1-6, wherein the composition comprises a mixed solvent (Y').

8. A pattern-forming method comprising:

   forming a resist film on a substrate (10);
   forming a protective film from the composition as defined in any one of the claims 1-7 on the resist film;
   immersion exposing the resist film so as to form an exposed resist film; and
   developing the exposed resist film.

## Patentansprüche

1. Verfahren zum Bilden eines Schutzfilms mit einer Trockenfilm-Auflösungsgeschwindigkeit in einem Alkali-Entwickler von 20 bis 300 nm/Sekunde für die Immersionsbelichtung, umfassend die Schritte
Beschichten einer Zusammensetzung, die ein wasserunlösliches Harz (X) umfasst, auf ein Substrat und
Trocknen der Zusammensetzung,
worin das wasserunlösliche Harz (X)
eine Restmonomermenge von 5 Masse% oder weniger in Bezug auf das wasserunlösliche Harz (X) aufweist und
mindestens eine Wiederholungseinheit enthält, ausgewählt aus
einer Wiederholungseinheit (X-1), erhalten aus einem Monomer mit einem pKa-Wert von kleiner als 8, und
einer Wiederholungseinheit (X-2), erhalten aus einem Monomer mit einem pKa-Wert von 8 oder größer, worin
wenn das wasserunlösliche Harz (X) die Wiederholungseinheit (X-1) enthält, der Säurewert (in Milliäquivalent/g) des wasserunlöslichen Harzes (X) von 1,0 bis 5,0 beträgt und
wenn das wasserunlösliche Harz (X) die Wiederholungseinheit (X-2) enthält, der Säurewert (in Milliäquivalent/g) des wasserunlöslichen Harzes (X) von 3,0 bis 7,0 beträgt und
wenn das wasserunlösliche Harz (X) sowohl die Wiederholungseinheit (X-1) als auch die Wiederholungseinheit (X-2) enthält, der Säurewert (in Milliäquivalent/g) des wasserunlöslichen Harzes (X) von 2,0 bis 5,0 beträgt.

2. Verfahren gemäß Anspruch 1, worin das Monomer mit einem pKa-Wert von kleiner als 8 ein Monomer ist, enthaltend eine Säuregruppe, die ausgewählt ist aus Carbonsäuren, Ammoniumsalzen und Pyridiniumsalzen.

3. Verfahren gemäß Anspruch 1 oder 2, worin das Monomer mit einem pKa-Wert von 8 oder größer ein Monomer ist, das eine Säuregruppe enthält, die ausgewählt ist aus einer phenolischen Hydroxylgruppe, einer Sulfonamidgruppe, $-COCH_2CO-$ und einer Fluoralkoholgruppe.

4. Verfahren gemäß irgendeinem der Ansprüche 1 bis 3, worin die Auflösungsgeschwindigkeit in einem Alkali-Entwickler von 25 bis 200 nm/Sekunde beträgt.

5. Verfahren gemäß irgendeinem der Ansprüche 1 bis 4, worin die Auflösungsgeschwindigkeit in einem Alkali-Entwickler von 30 bis 90 nm/Sekunde beträgt.

6. Verfahren gemäß irgendeinem der Ansprüche 1 bis 5, worin die Zusammensetzung ein Tensid (Z) umfasst.

7. Verfahren gemäß irgendeinem der Ansprüche 1 bis 6, worin die Zusammensetzung ein gemischtes Lösungsmittel (Y') umfasst.

8. Strukturbildendes Verfahren, umfassend:

Bilden eines Resistfilms auf einem Substrat (10);
Bilden eines Schutzfilms aus der Zusammensetzung, wie sie in irgendeinem der Ansprüche 1 bis 7 definiert ist, auf dem Resistfilm;
Immersionsbelichten des Resistfilms, um so einen belichteten Resistfilm zu bilden; und
Entwickeln des belichteten Resistfilms.

**Revendications**

1. Procédé de formation d'un film de protection ayant une vitesse de dissolution de film sec dans un révélateur alcalin allant de 20 à 300 nm/s pour une exposition par immersion, comprenant les étapes qui consistent à déposer une composition comprenant une résine insoluble dans l'eau (X) sur un substrat et à sécher la composition,
dans lequel la résine insoluble dans l'eau (X) a une quantité de monomère résiduel inférieure ou égale à 5% en masse par rapport à la résine insoluble dans l'eau (X) et contient au moins une unité de répétition choisie parmi une unité de répétition (X-1) dérivée d'un monomère ayant un pKa inférieur à 8, et
une unité de répétition (X-2) dérivée d'un monomère ayant un pKa supérieur ou égal à 8, où
lorsque la résine insoluble dans l'eau (X) contient une unité de répétition (X-1), l'indice d'acidité (milliéquivalent/g) de la résine insoluble dans l'eau (X) varie de 1,0 à 5,0 et
lorsque la résine insoluble dans l'eau (X) contient une unité de répétition (X-2), l'indice d'acidité (milliéquivalent/g) de la résine insoluble dans l'eau (X) varie de 3,0 à 7,0 et
lorsque la résine insoluble dans l'eau (X) contient à la fois une unité de répétition (X-1) et une unité de répétition (X-2), l'indice d'acidité (milliéquivalent/g) de la résine insoluble dans l'eau (X) varie de 2,0 à 5,0.

2. Procédé de la revendication 1, dans lequel le monomère ayant un pKa inférieur à 8 est un monomère contenant un groupe acide qui est choisi parmi des acides carboxyliques, des sels d'ammonium et des sels de pyridinium.

3. Procédé de la revendication 1 ou 2, dans lequel le monomère ayant un pKa supérieur ou égal à 8 est un monomère contenant un groupe acide qui est choisi parmi un groupe hydroxyle phénolique, un groupe sulfonamide, un $-COCH_2CO-$, et un groupe fluoroalcool.

4. Procédé de l'une quelconque des revendications 1 à 3, dans lequel la vitesse de dissolution dans un révélateur alcalin varie de 25 à 200 nm/s.

5. Procédé de l'une quelconque des revendications 1 à 4, dans lequel la vitesse de dissolution dans un révélateur alcalin varie de 30 à 90 nm/s.

6. Procédé de l'une quelconque des revendications 1 à 5, dans lequel la composition comprend un tensioactif (Z).

**7.** Procédé de l'une quelconque des revendications 1 à 6, dans lequel la composition comprend un solvant mixte (Y').

**8.** Procédé de formation de motif comprenant le fait :

de former un film de réserve sur un substrat (10) ;
de former un film de protection à partir de la composition telle que définie dans l'une quelconque des revendications 1 à 7 sur le film de réserve ;
d'exposer par immersion, le film de réserve de manière à former un film de réserve exposé ; et
de développer le film de réserve exposé.

Fig. 1

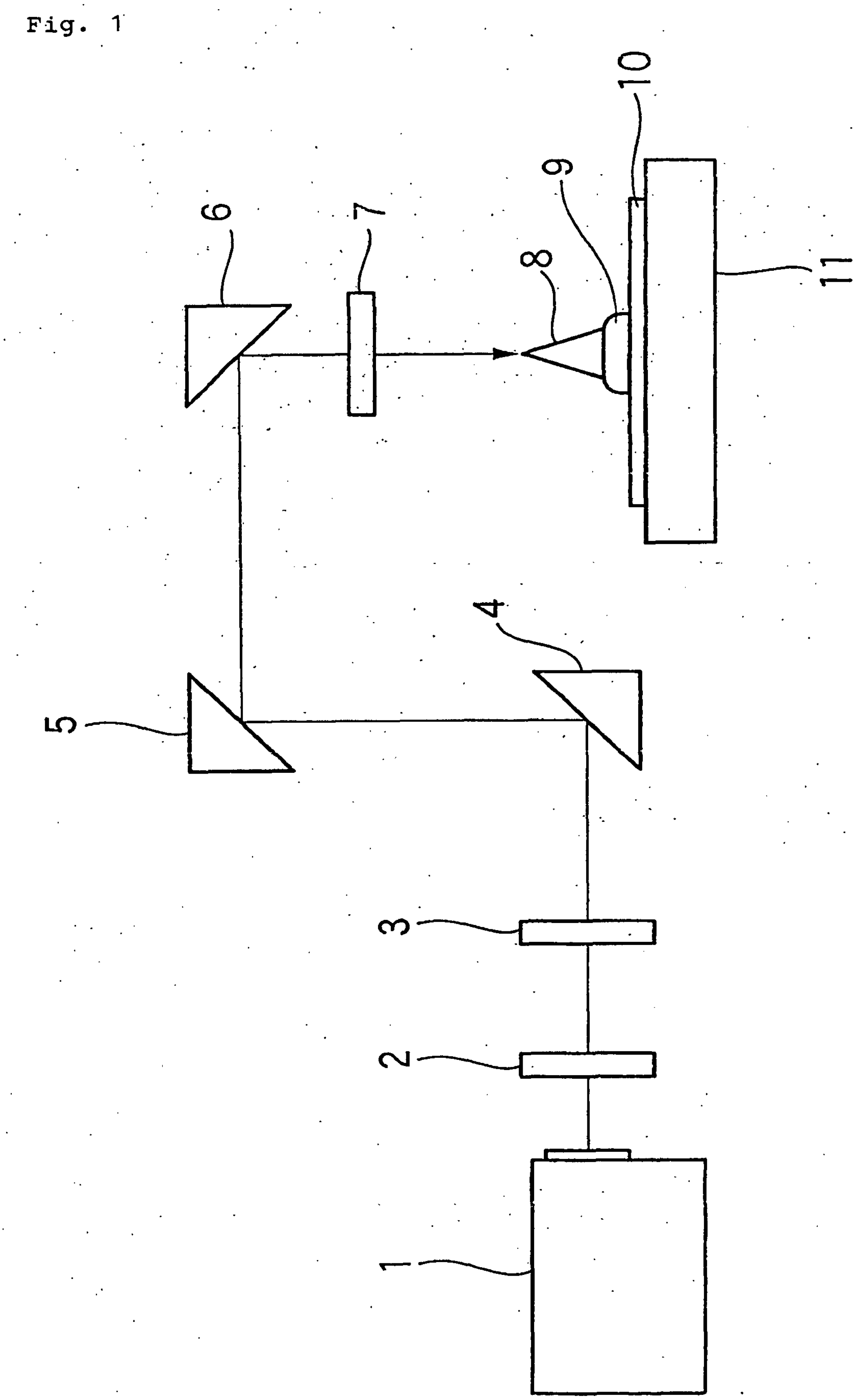

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 57153433 A
- JP 7220990 A
- US 5955241 A
- JP 10303114 A
- US 20040075895 A1
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- JP 2002277862 A
- US 5405720 A
- US 5360692 A
- US 5529881 A
- US 5296330 A
- US 5436098 A
- US 5576143 A
- US 5294511 A
- US 5824451 A
- JP 2002090991 A
- JP 7069611 B
- US 5294680 A
- JP 6118631 A
- JP 6118656 A
- JP 8007115 A
- JP 8179509 A
- JP 2000275845 A
- JP 2003167347 A
- JP 2002012622 A
- JP 2003177538 A


### Non-patent literature cited in the description


- **S. KISHIMURA et al.** *Proceedings of SPIE,* February 2004, vol. 5376, 44-55
- **D.S. HALL et al.** *Proceedings of SPIE,* February 2001, vol. 4345, 1066-1072
- **T. OHFUJI et al.** *Proceedings in SPIE,* February 1996, vol. 2724, 386-398
- **T. ISHIKAWA et al.** *Proceedings in SPIE,* February 2004, vol. 5376, 169-177
- *SPIE Proc.,* 2002, vol. 4688, 11
- *J. Vac. Sci. Tecnol. B,* 1999, 17
- Kagaku Binran II. Maruzen Co, 1993